(19) Europäisches Patentamt
European Patent Office
Office européen des brevets

(11) EP 4 235 789 A1

(12) **EUROPEAN PATENT APPLICATION**

(43) Date of publication:
**30.08.2023 Bulletin 2023/35**

(21) Application number: **23158012.7**

(22) Date of filing: **22.02.2023**

(51) International Patent Classification (IPC):
*H01L 27/12* (2006.01)     *H01L 29/66* (2006.01)

(52) Cooperative Patent Classification (CPC):
**H01L 27/1233; H01L 27/1229; H01L 29/66757**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **24.02.2022 KR 20220024177**

(71) Applicant: **Samsung Display Co., Ltd.**
**Yongin-si, Gyeonggi-do 17113 (KR)**

(72) Inventor: **KIM, Keun Woo**
**Yongin-si (KR)**

(74) Representative: **Marks & Clerk LLP**
**15 Fetter Lane**
**London EC4A 1BW (GB)**

(54) **DISPLAY DEVICE AND METHOD OF FABRICATING THE SAME**

(57) A display device includes a substrate, a first active layer including a driving active pattern of a driving transistor disposed on the substrate and a first active pattern of a first transistor disposed on the substrate, a second active layer including a driving sub-active pattern disposed on the driving active pattern of the first active layer, a first insulating film disposed on the first active layer and the second active layer, a driving gate electrode disposed on the first insulating film and overlapping the driving sub-active pattern, and a first gate electrode disposed on the first insulating film and overlapping the first active pattern, where a thickness of the driving active pattern is greater than a thickness of the driving sub-active pattern.

# FIG. 5A

GTL1: G1, DT_G1, G6, CE21
GTL2: CE22
DTL: DL, DT_G2, ANDE
61: DT_ACT, DT_S, DT_D
62: ACT1-1, S1-1, D1-1, ACT1-2, S1-2, D1-2
50: 51, 52
ACT1: 61, 62
ACT: ACT1, 50

EP 4 235 789 A1

**Description**

BACKGROUND

1. Field

The disclosure relates to a display device and a method of fabricating the display device.

2. Description of the Related Art

As the information-oriented society evolves, various demands for display devices are ever increasing. For example, display devices are being employed by a variety of electronic devices such as smart phones, digital cameras, laptop computers, navigation devices, and smart televisions. Display devices may be flat panel display devices such as a liquid-crystal display device, a field emission display device, and an organic light-emitting display device. Among such flat panel display devices, a light-emitting display device includes a plurality of pixels each including a light-emitting element that emits light, so that each of the pixels of the display panel may emit light by themselves. Accordingly, a light-emitting display device can display images without a backlight unit that supplies light to the display panel.

Each of the plurality of pixels of the display panel may include a plurality of thin-film transistors. Each of the plurality of thin-film transistors includes a semiconductor layer. Silicon (Si) is the most widely used as the material for the semiconductor layer of a thin-film transistor. Silicon may be typically classified into amorphous silicon and polycrystalline silicon based on the crystal form. Since polycrystalline silicon has high charge mobility, polycrystalline silicon is widely used to fabricate high-performance thin-film transistors.

SUMMARY

In a display panel where a pixel includes a polysilicon thin-film transistor, while the polysilicon thin-film transistor is turned off, a leakage current may flow due to an electric field between the channel region and the source/drain region of the thin-film transistor. When a display device is driven at a low frame frequency to reduce power consumption when displaying a still image, the emission time of the plurality of pixels may increase, and the luminance of the plurality of pixels may be lowered due to a leakage current.

Embodiments of the disclosure provide a display device that can preventing a decrease in luminance of a plurality of pixels due to a leakage current even when it is driven at a low frame frequency to reduce power consumption when displaying a still image.

According to an embodiment of the disclosure, a display device include a substrate, a first active layer including a driving active pattern of a driving transistor disposed on the substrate and a first active pattern of a first transistor disposed on the substrate, a second active layer including a driving sub-active pattern disposed on the driving active pattern of the first active layer, a first insulating film disposed on the first active layer and the second active layer, a driving gate electrode disposed on the first insulating film and overlapping the driving sub-active pattern, and a first gate electrode disposed on the first insulating film and overlapping the first active pattern, where a thickness of the driving active pattern is greater than a thickness of the driving sub-active pattern.

In an embodiment, the second active layer may further include a first sub-active pattern disposed on the first active pattern, and a thickness of the first active pattern may be greater than a thickness of the first sub-active pattern.

In an embodiment, the thickness of the driving sub-active pattern may be smaller than the thickness of the first sub-active pattern.

In an embodiment, the thickness of the first sub-active pattern may be less than about 20 angstrom (Å).

In an embodiment, the thickness of the driving sub-active pattern may be greater than or equal to about 20 Å and less than about 100 Å.

In an embodiment, the first active layer may include polycrystalline silicon, wherein the driving sub-active pattern may include amorphous silicon, and the first sub-active pattern may include the amorphous silicon and hydrogen atoms bonded thereto.

In an embodiment, the first active pattern may include a first channel, a first source electrode and a first drain electrode, and the first sub-active pattern may overlap with the first channel but not with the first source electrode or the first drain electrode.

In an embodiment, the driving active pattern may include a driving channel, a driving source electrode, and a driving drain electrode, and the driving sub-active pattern may overlap with the driving channel but not with the driving source electrode and the driving drain electrode.

In an embodiment, the driving sub-active pattern may include first protrusions protruding from an upper surface thereof, the first sub-active pattern may include second protrusions protruding from an upper surface thereof, and where a height of the second protrusions may be smaller than a height of the first protrusion.

In an embodiment, the first active pattern may include third protrusions protruding from an upper surface thereof, and the height of the second protrusion may be smaller than a height of the third protrusions.

According to an embodiment of the disclosure, a display device include a write scan line from which a write scan signal is applied, and a sub-pixel connected to the write scan line, where the sub-pixel includes a light-emitting element, a driving transistor which provides a driving current flowing to the light-emitting element in response to a voltage of a gate electrode, and a first transistor which controls a connection between the gate electrode and a first electrode of the driving transistor in response to the write scan signal from the write scan line, and wherein the first transistor includes a first active pattern including a first material, and a first sub-active pattern disposed on the first active pattern and including a second material different from the first material, and where a thickness of the first active pattern is greater than a thickness of the first sub-active pattern.

In an embodiment, the driving transistor may include a driving active pattern including the first material, and a driving sub-active pattern disposed on the driving active pattern and including a third material different from the first material and the second material, and where a thickness of the driving sub-active pattern may be greater than the thickness of the first sub-active pattern.

In an embodiment, the first material may include polycrystalline silicon, where the second material may include amorphous silicon and hydrogen atoms bonded thereto, and the third material may include the amorphous silicon.

In an embodiment, the display device may further include an initialization scan line from which an initialization scan signal is applied, and a second transistor which controls a connection between the gate electrode of the driving transistor and an initialization voltage line from which an initialization voltage is applied in response to the initialization scan signal of the initialization scan line, where the second transistor may include a second active pattern including a first material and a second sub-active pattern disposed on the second active pattern and including the second material.

In an embodiment, a thickness of the driving sub-active pattern may be smaller than a thickness of the second sub-active pattern.

In an embodiment, the thickness of the second sub-active pattern mat be less than about 20 Å.

In an embodiment, the display device may further include a data line from which a data voltage is applied, and a third transistor which controls a connection between the data line and a second electrode of the driving transistor in response to the write scan signal of the write scan line, where the third transistor may include a third active pattern including the first material and an insulating film disposed on the third active pattern, and where the third active pattern may be in contact with the insulating film.

In an embodiment, the display device may further include a data line from which a data voltage is applied, and a timing controller which controls drivers in a way such that the write scan signal and the data voltage are supplied at a frame frequency of 60 Hz or higher in a first driving mode, and the write scan signal and the data voltage are supplied at a frame frequency of less than 60 Hz in a second driving mode.

According to an embodiment of the disclosure, a method of fabricating a display device include providing a first active layer including polycrystalline silicon on a substrate, providing a second active layer including amorphous silicon on the first active layer, patterning the first active layer and the second active layer simultaneously to form a driving active pattern including the polycrystalline silicon, a driving sub-active pattern including the amorphous silicon, a first active pattern including the polycrystalline silicon and a first sub-active pattern including the amorphous silicon, disposing a mask above the driving sub-active pattern, and etching a part of the first sub-active pattern.

In an embodiment, the method of fabricating a display device may further include performing hydrogen plasma treatment on the first sub-active pattern.

According to embodiments of the invention, by forming a sub-active pattern on at least some of the transistors including polycrystalline semiconductor included in a pixel in a display device, a leakage current may be suppressed below a certain level. Therefore, it is possible to prevent the display luminance from decreasing even when the display device is driven with a low frame frequency when displaying a still image to reduce power consumption, and thus flicking is not recognized.

In an embodiment, by forming the driving sub-active pattern of the driving transistors including polycrystalline semiconductor included in a pixel, the driving voltage range of the driving transistor may be increased, thereby preventing Mura and improving image quality.

It should be noted that effects of the disclosure are not limited to those described above and other effects of the disclosure will be apparent to those skilled in the art from the following descriptions.

At least some of the above and other features of the invention are set out in the claims.

BRIEF DESCRIPTION OF THE DRAWINGS

The above and other features of the disclosure will become more apparent by describing in detail embodiments thereof with reference to the accompanying drawings, in which:

FIG. 1 is a perspective view of a display device according to an embodiment of the disclosure;
FIG. 2 is a block diagram showing a display device according to an embodiment of the disclosure;
FIG. 3 is a circuit diagram showing a sub-pixel according to an embodiment of the disclosure in detail;
FIG. 4 is a circuit diagram showing a driving transistor, a first transistor according to an embodiment;
FIG. 5A is a cross-sectional view showing a driving transistor, a first transistor and a sixth transistor according to an embodiment;
FIG. 5B is an enlarged view of the encircled area between area A and area B of FIG. 5A;
FIG. 6 is an enlarged cross-sectional view of area A of FIG. 5A;
FIG. 7 is an enlarged cross-sectional view of area B of FIG. 5A;
FIG. 8 is a graph showing the driving voltage range versus driving current according to an embodiment of the disclosure;

FIG. 9 is a flowchart for illustrating a method of fabricating a display device according to an embodiment of the disclosure;

FIGS. 10 to 13B are cross-sectional views showing processing steps of a method of fabricating a display device according to an embodiment of the disclosure;

FIG. 14 is a cross-sectional view showing a second transistor according to an alternative embodiment;

FIG. 15 is a cross-sectional view showing a driving transistor, a first transistor and a sixth transistor according to an alternative embodiment;

FIG. 16 is an enlarged, cross-sectional view of area C of FIG. 15;

FIG. 17 is a cross-sectional view showing a driving transistor, a first transistor and a sixth transistor according to an alternative embodiment;

FIG. 18 is an enlarged cross-sectional view of area D of FIG. 17;

FIG. 19 is a flowchart for illustrating a method of fabricating a display device according to an alternative embodiment of the disclosure; and

FIGS. 20 to 21B are cross-sectional views for illustrating a method of fabricating a display device according to an alternative embodiment of the disclosure.

DETAILED DESCRIPTION

The invention will now be described more fully hereinafter with reference to the accompanying drawings, in which various embodiments of the invention are shown. This invention may, however, be embodied in different forms and should not be construed as limited to the embodiments set forth herein. Rather, these embodiments are provided so that this disclosure will be thorough and complete, and will filly convey the scope of the invention to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the present invention. Similarly, the second element could also be termed the first element.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within $\pm$ 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments of the disclosure will be described with reference to the accompanying drawings.

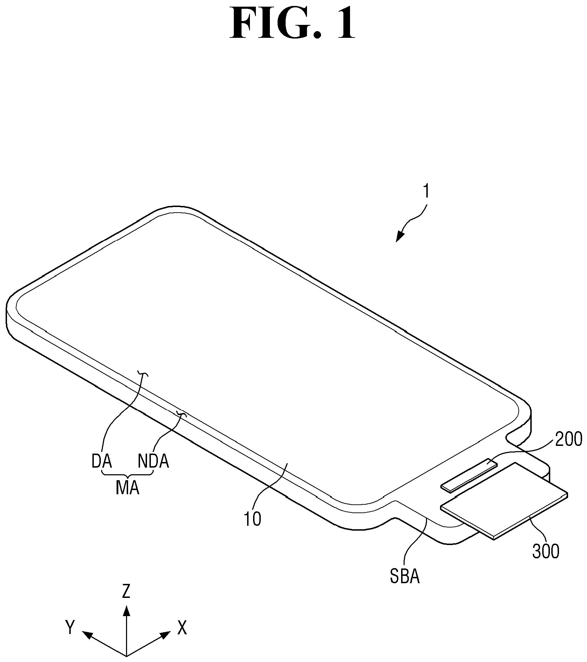

FIG. 1 is a perspective view of a display device according to an embodiment of the disclosure.

Referring to FIG. 1, an embodiment of a display device 1 is a device that displays moving images or still images. The display device 1 may be used as the display screen of portable electronic devices such as a mobile phone, a smart phone, a tablet personal computer (PC), a smart watch, a watch phone, a mobile communications terminal, an electronic notebook, an electronic book, a portable multimedia player (PMP), a navigation device and a ultra mobile PC (UMPC), as well as the display screen of various products such as a television, a notebook, a monitor, a billboard and the Internet of Things.

The display device 1 may be a light-emitting display device such as an organic light-emitting display device using organic light-emitting diodes, a quantum-dot light-emitting display device including quantum-dot light-emitting layer, an inorganic light-emitting display device including an inorganic semiconductor, and an ultra-small light-emitting display device using micro or nano light-emitting diodes (LEDs). In the following description, for convenience, embodiments where the display device 1 is an organic light-emitting display device will be described in detail. It is, however, to be understood that the disclosure is not limited thereto.

In an embodiment, the display device 1 includes a display panel 10, a display driver circuit 200 and a circuit board 300.

The display panel 10 may be formed in a rectangular plane having shorter sides in a first direction X and longer sides in a second direction Y intersecting the first direction X. Each of the corners where the shorter side in the first direction X meets the longer side in the second direction Y may be a right angle or may be rounded with a predetermined curvature. The shape of the display panel 10 when viewed from the top (or in a top plan view or a plan view in a third direction Z) is not limited to a quadrangular shape, but may be formed in a different polygonal shape, a circular shape, or an elliptical shape. The display panel 10 may be formed flat, but is not limited thereto. In an embodiment, for example, the display panel 10 may be formed at left and right ends, and may include a curved portion having a constant curvature or a varying curvature. In addition, the display panel 10 may be flexible so that the display panel 10 may be curved, bent, folded or rolled.

A substrate of the display panel 10 may include a main area MA and a subsidiary area SBA.

The main area MA may include a display area DA where images are displayed, and a non-display area NDA around the display area DA.

The display area DA may include display pixels PX for displaying images. In addition, the display area DA may include photo-sensing pixels PS that not only display images but also sense light to detect a user's fingerprint. The display area DA may occupy most of the main area MA. The display area DA may be disposed at the center of the main area MA.

The non-display area NDA may be disposed adjacent to the display area DA. The non-display area NDA may be disposed on the outer side of the display area DA. The non-display area NDA may surround the display area DA. The non-display area NDA may be defined as the border of the display panel 10.

The subsidiary area SBA may protrude from one side of the main area MA in the second direction Y. The length of the subsidiary area SBA in the second direction Y may be smaller than the length of the main area MA in the second direction Y. The length of the subsidiary area SBA in the first direction X may be substantially less than or substantially equal to the length of the main area MA in the first direction X.

Although FIG. 1 shows an embodiment in a state where the subsidiary area SBA is unfolded, the subsidiary area SBA may be bent. When the subsidiary area SBA is bent, the subsidiary area SBA may be disposed under the main area MA and thus may overlap with the main area MA in the third direction Z.

The display driver circuit 200 may generate signals and voltages for driving the display panel 10. The display driver circuit 200 may be implemented as an integrated circuit (IC) and may be attached to the subsidiary area SBA of the display panel 10 by a chip on glass (COG) technique, a chip on plastic (COP) technique, or an ultrasonic bonding. It is, however, to be understood that the disclosure is not limited thereto. In an alternative embodiment, for example, the display driver circuit 200 may be attached on the circuit board 300 by the chip-on-film (COF) technique.

The circuit board 300 may be attached to one end of the subsidiary area SBA of the display panel 10. Accordingly, the circuit board 300 may be electrically connected to the display panel 10 and the display driver circuit 200. The display panel 10 and the display driver circuit 200 may receive digital video data, timing signals, and driving voltages through the circuit board 300. The circuit board 300 may be a flexible printed circuit board, a printed circuit board, or a flexible film such as a chip on film.

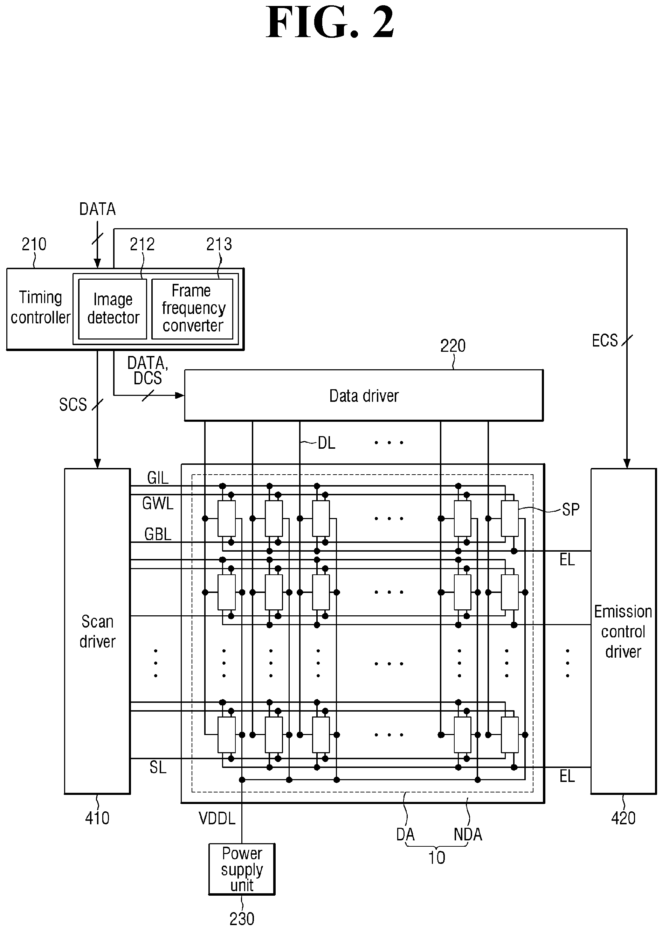

FIG. 2 is a block diagram showing a display device according to an embodiment of the disclosure.

Referring to FIG. 2, the display device according to the embodiment includes a display panel 10, a scan driver 410, an emission driver 420, a display driver circuit 200, and a power supply unit 230. The display driver circuit 200 may include a data driver 220 and a timing controller 210.

The display panel 10 may include sub-pixels SP disposed in the display area DA, scan write lines GWL, scan initialization lines GIL, scan bias lines GBL, emission lines EL and data lines DL . The display panel 10 may further include the scan driver 410 and the emission driver 420 disposed in the non-display area NDA.

The scan write lines GWL, the scan initialization lines GIL, the scan bias lines GBL and the emission lines EL may be extended in the first direction X. The data lines DL may be extended in the second direction Y.

The sub-pixels SP may be disposed in the display area DA. Each of the sub-pixels SP may be connected to a corresponding one of the scan write lines GWL, a corresponding one of the scan initialization lines GIL, a corresponding one of the scan bias lines GBL, a corresponding one of the emission lines EL, and a corresponding one of the data lines DL. Each of the sub-pixels SP may be controlled by a scan write signal of the scan write line GWL, a scan initialization signal of the scan initialization line GIL, a scan bias signal of the scan bias line GBL and an emission signal of the emission line EL, to receive the data voltage of the data line DL, and may emit light by applying a driving current to the light-emitting element in response to the data voltage.

The scan driver 410 may be connected to the scan write lines GWL, the scan initialization lines GIL, and the scan bias lines GBL. The scan driver 410 may receive a scan control signal SCS from the timing controller 210. The scan control signal SCS may include first to third scan control signals. The scan driver 410 may generate scan write signals in response to the first scan control signal and output the scan write signals to the scan write lines GWL. In addition, the scan driver 410 may generate scan initialization signals in response to the second scan control signal and output the scan initialization signals to the scan initialization lines GIL. Furthermore, the scan driver 410 may generate scan bias signals in response to the third scan control signal and output the scan bias signals to the scan bias lines GBL.

The emission driver 420 may be connected to the emission lines EL. The emission driver 420 may receive an emission control signal ECS from the timing controller 210. The emission driver 420 may generate emission signals in response to the emission control signal ECS and output the emission signals to the display emission lines EL.

The data driver 220 converts digital video data DATA into data voltages and outputs the data voltages to the data lines DL. The data driver 220 may output data voltages in synchronization with the scan write signals. Therefore, the sub-pixels SP are selected by the scan write signals of the scan driver 410, and a data voltage may be applied to each of the selected sub-pixels SP.

The timing controller 210 receives the digital video data DATA and timing signals from an external graphic device. In an embodiment, for example, the external graphic device may be, but is not limited to, a graphic card of a computer, a set-top box, an application processor of a smart phone or a mobile phone, etc.

The timing controller 210 may generate the scan control signal SCS for controlling the operation timing of the scan driver 410 in response to the timing signals and may generate the emission control signal ECS for controlling the operation timing of the emission control driver 420 in response to the timing signals. In addition, the timing controller 210 may generate a data control signal DCS for controlling the operation timing of the data driver 220 in response to the timing signals.

The timing controller 210 outputs the scan control signal SCS to the scan driver 410 and outputs the emission control signal ECS to the emission driver 420. The timing controller 210 may output the digital video data DATA and the data control signal DCS to the data driver 220.

The timing controller 210 includes an image detector 212 and a frame frequency converter 213.

The image detector 212 may receive an image signal. The image detector 212 may generate a mode control signal for changing or determining the current frame frequency (i.e., a frequency of a current frame) to change or variably control the frame frequency. In an embodiment, for example, the image detector 212 may determine whether the image signal is a still image or a moving image by comparing the currently input image signal with the image signal of the previous frame. When the input image is a still image, the image detector 212 may output a mode control signal having a first logic level so that the display device 1 is driven in a first driving mode having a first frame frequency to reduce power consumption. When the input image is a moving image, the image detector 212 may output a mode control signal having a second logic level so that the display device 1 is driven in a second driving mode having a second frame frequency.

The second frame frequency may be higher than the first frame frequency. In an embodiment, for example, the first frame frequency may be a frequency of less than 60 hertz (Hz), for example, a frequency between 1 Hz and 60 Hz, and the second frame frequency may be a frequency of 60 Hz or more, but the disclosure is not limited thereto. The image detector 212 may output the mode control signal to the frame frequency converter 213.

The frame frequency converter 213 may receive the mode control signal from the image detector 212. The frame frequency converter 213 may generate the scan control signal SCS and the data control signal DCS based on the mode control signal. In an embodiment, for example, the frame frequency converter 213 may generate the scan control signal SCS, the emission control signal ECS and the data control signal DCS which have the first frame frequency based on the mode control signal of the first logic level voltage in the first driving mode. The frame frequency converter 213 may generate the scan control signal SCS, the emission control signal ECS and the data control signal DCS which have the second frame frequency based on the mode control signal of the second logic level voltage in the second driving mode.

The frame frequency converter 213 in the first driving mode may output the scan control signal SCS, the emission control signal ECS and the data control signal DCS, each having the first frame frequency, to the scan driver 410, the emission driver 420 and the data driver 220, respectively. The frame frequency converter 213 in the second driving mode may output the scan control signal SCS, the emission control signal ECS and the data control signal DCS, each having the second frame frequency, to the scan driver 410, the emission driver 420 and the data driver 220, respectively.

The power supply unit 230 may generate driving voltages and output the driving voltages to the display panel 10. The power supply unit 230 may output a first supply voltage VDD, a second supply voltage VSS, a first initialization voltage VINT1 and a second initialization voltage VINT2 to the display panel 10. The first supply voltage VDD may be a high-level driving voltage, and the second supply voltage VSS may be a low-level driving voltage.

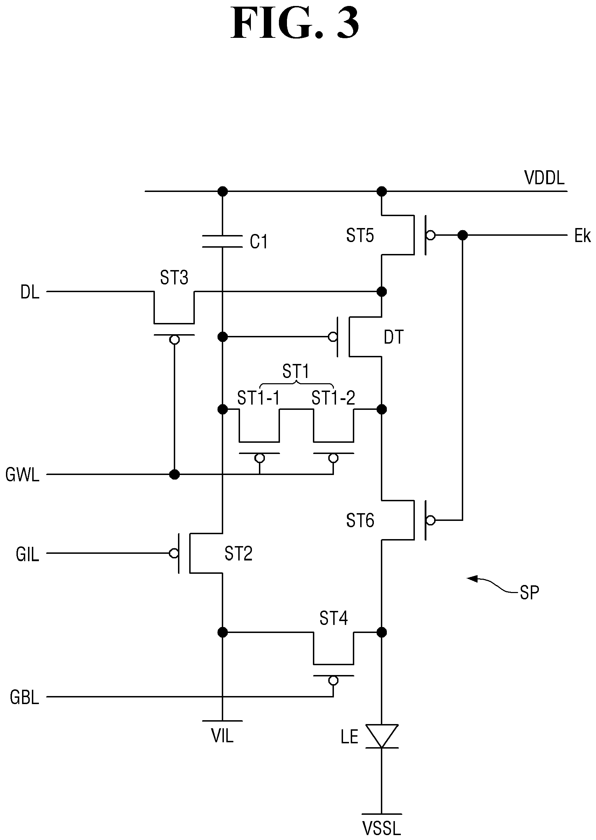

FIG. 3 is a circuit diagram showing a sub-pixel according to an embodiment of the disclosure in detail.

Referring to FIG. 3, an embodiment of the sub-pixel SP may include a pixel driver, and the pixel driver may include a driving transistor DT, first to sixth transistors ST1 to ST6, and a first capacitor C1.

The driving transistor DT controls the driving current in response to the data voltage applied to the gate electrode.

The first transistor ST1 is turned on by the scan signal of the scan write line GWL to connect the gate electrode with the second electrode of the driving transistor DT. The second transistor ST2 is turned on by the scan signal of the scan initialization line GIL to connect the gate electrode of the driving transistor DT with the initialization voltage line VIL. The third transistor ST3 is turned on by the scan signal of the scan write line GWL to supply the data voltage of the data line DL to the first electrode of the driving transistor DT. The fourth transistor ST4 is turned on by the scan signal of the scan bias line GBL to connect the anode electrode of the light-emitting element LE with the initialization voltage line VIL. The fifth transistor ST5 is turned on by the emission control signal of the emission line EL to connect the first electrode of the driving transistor DT with a first supply voltage line VDDL. The sixth transistor ST6 is connected between the second electrode of the driving transistor DT and the anode electrode of the light-emitting element EL. The first capacitor C1 is disposed between the gate electrode of the driving transistor DT and the first supply voltage line VDDL.

The light-emitting element LE may be connected between the first electrode of the fourth transistor ST4 and a second supply voltage line VSSL.

In an embodiment shown in FIG. 3, one of the first and second electrodes of each of the driving transistor DT and the first to sixth transistors ST1 to ST6 may be a source electrode, while the other one may be a drain electrode. In addition, although the driving transistor DT and the first to sixth transistors ST1 to ST6 are each implemented as a p-type metal oxide semiconductor field effect transistor (MOSFET) in FIG. 3, the embodiments of the disclosure are not limited thereto. In an alternative embodiment, for example, each of the first to sixth transistors T1 to T6 may be formed of an n-type MOSFET.

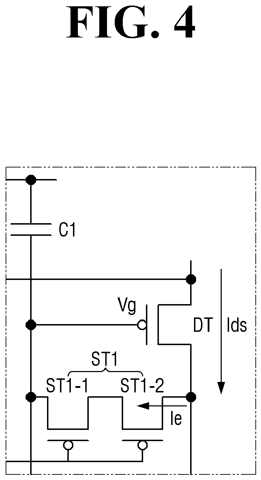

FIG. 4 is a circuit diagram showing a driving transistor and a first transistor according to an embodiment.

Referring to FIG. 4, the drain-source current Ids (hereinafter referred to as "driving current") of driving transistor DT is controlled based on the data voltage applied to the gate electrode. The driving current Ids flowing through the channel of the driving transistor DT is proportional to the square of the difference between the gate-source voltage (Vsg) and the threshold voltage of the driving transistor DT, as shown in Equation 1 below:

[Equation 1]

$$Ids = k' \times (Vsg - Vth)^2$$

In Equation 1, Vsg denotes the gate-source voltage of the driving transistor DT, Vth denotes the threshold voltage of the driving transistor DT, and k' denotes a proportional coefficient determined by the structure and physical properties of the driving transistor DT. The proportional coefficient k' may be affected or determined by the material between a gate electrode DT_G of the driving transistor DT and a channel region DT_ACT of the driving transistor DT. For example, when a driving sub-active pattern 51 is formed between the gate electrode DT_G of the driving transistor DT and the channel region DT_ACT of the driving transistor DT, the electron mobility of the channel region DT_ACT of the driving transistor DT may be lowered. The channel region DT_ACT of the driving transistor DT having the lowered electron mobility may decrease the amount of the driving current Ids versus the driving voltage. In other words, when the driving sub-active pattern 51 is formed, the proportional coefficient k' may become smaller. As the proportional coefficient k' becomes smaller, a driving voltage range of the driving transistor DT may increase in a range of a predetermined driving current Ids for representing the gray scale of the light-emitting element LE.

As described above, in an embodiment, by forming the driving sub-active pattern of the driving transistors including polycrystalline semiconductor included in a pixel, the driving voltage range of the driving transistor may be increased, thereby preventing Mura and improving image quality.

In addition, the first transistor ST1 may be implemented as a dual transistor including a first first transistor ST1-1 and a second first transistor ST1-2. When the first first transistor ST1-1 and the second first transistor ST1-2 are turned on, the gate electrode DT_G of the drive transistor DT is connected to the second electrode, and thus the drive transistor DT works as a diode.

Thereafter, even when the first first transistor ST1-1 and the second first transistor ST1-2 are turned off, and the driving current Ids flowing in response to the voltage of the gate electrode DT_G of the driving transistor DT is supplied to the light-emitting element LE, there may be a leak current Ie from the source electrodes S1-1 and S1-2 toward the drain electrode D1-1 and D1-2 of the first first transistor ST1-1 and the second first transistor ST1-2. When the leak current Ie is generated, the voltage due to the leakage current Ie may be reflected to the gate electrode DT_G of the driving transistor DT. Accordingly, the driving current Ids is affected by a voltage change of the gate electrode DT_G of the driving transistor DT, and the amount of light emitted from the light-emitting element LE is changed. As a result, the display luminance may be decreased and flickering may be recognized.

In an embodiment, by forming the first sub-active pattern 52 on at least some of the transistors including the plurality of polycrystalline semiconductors included in the light-emitting element LE, the leakage current Ie may be suppressed below a certain level. Therefore, it is possible to prevent the display luminance from decreasing even if the display device is driven with the first frame frequency when displaying a still image to reduce power consumption, and thus flicking is not recognized.

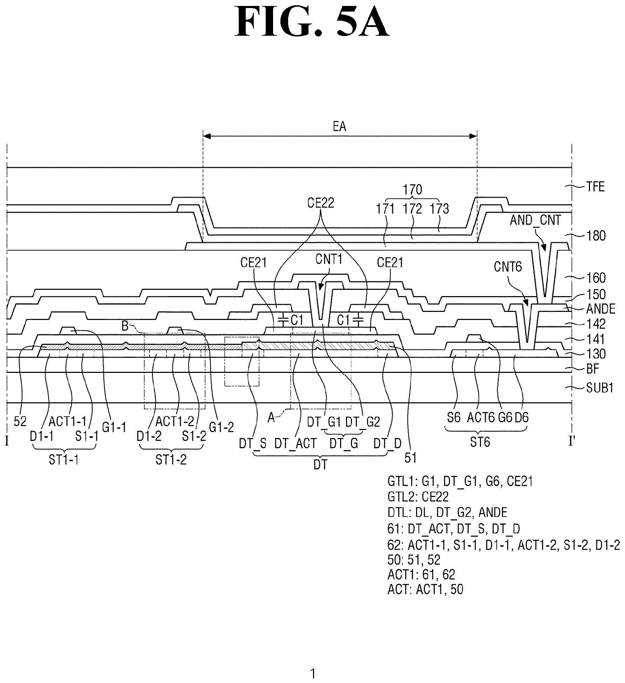

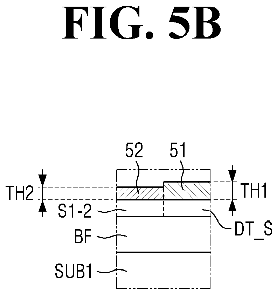

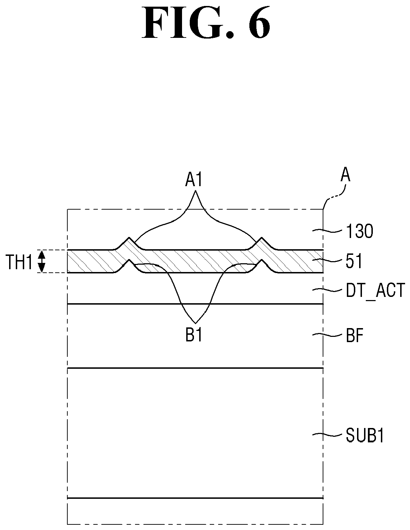

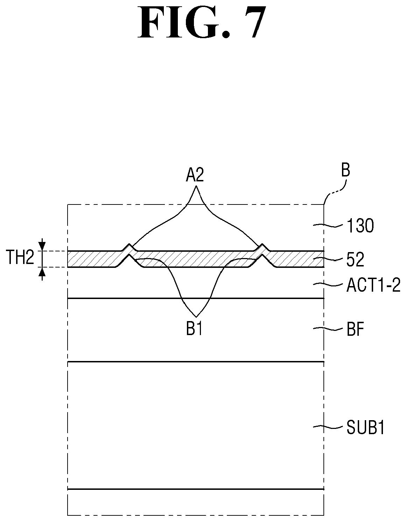

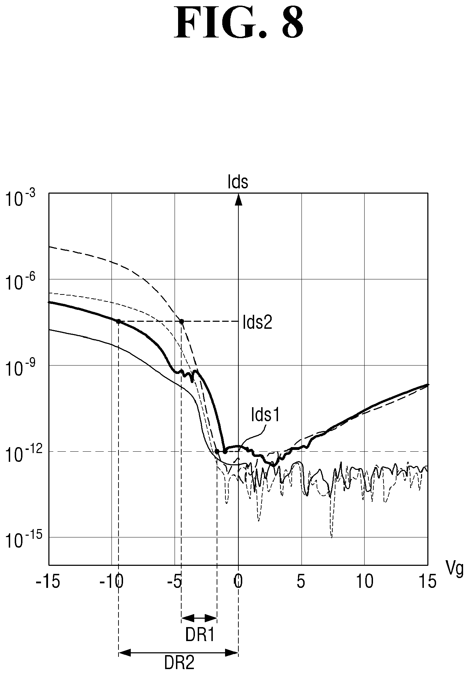

FIG. 5A is a cross-sectional view showing a driving transistor, a first transistor and a sixth transistor according to an embodiment, and FIG. 5B is an enlarged view of the encircled area between area A and area B of FIG. 5A. FIG. 6 is an enlarged cross-sectional view of area A of FIG. 5A. FIG. 7 is an enlarged cross-sectional view of area B of FIG. 5A. FIG. 8 is a graph showing the driving voltage range versus driving current according to an embodiment of the disclosure. Referring to FIGS. 5A to 8, a thin-film transistor TFTL, a light-emitting element layer EML, and an encapsulation layer TFE may be sequentially disposed or formed on a first substrate SUB1.

The thin-film transistor TFTL includes a buffer film BF, an active layer ACT, a first gate layer GTL1, a second gate layer GTL2, a data metal layer DTL, a gate insulator 130, a first interlayer dielectric film 141, a second interlayer dielectric film 142, a protective layer 150, and a planarization layer 160.

The buffer film BF may be disposed or formed on a surface of the first substrate SUB1. The buffer film BF may be disposed or formed on the surface of the first substrate SUB1 to protect the thin-film transistors 120 and an organic emitting layer 172 of the light-emitting element layer EML from moisture that is likely to permeate through the first substrate SUB1. The buffer layer BF may be defined by or formed of a plurality of inorganic layers alternately stacked on one another. In an embodiment, for example, the buffer layer BF may be made up of multiple layers in which one or more inorganic layers of a silicon nitride layer, a silicon oxynitride layer, a silicon oxide layer, a titanium oxide layer and an aluminum oxide layer are alternately stacked on one another. Alternatively, the buffer film BF may be omitted.

The active layer ACT may be disposed or formed on the first substrate SUB1 or the buffer film BF. The active layer ACT may include polycrystalline silicon, single crystal silicon, low-temperature polycrystalline silicon, amorphous silicon, or an oxide semiconductor.

Referring to FIGS. 5B, 6 and 7, the active layer ACT includes a first active layer ACT1 and a second active layer 50.

The first active layer ACT1 may include a driving active pattern 61 of the driving transistor DT, and a first active pattern 62 of the first transistor ST1.

In an embodiment, where the driving active pattern 61 and the first active pattern 62 include or are made of polycrystalline silicon, and the driving active pattern 61 and the first active pattern 62 are doped with ions, the ion-doped driving active pattern 61 and the first active pattern 62 may have conductivity. Accordingly, the driving active pattern 61 may include a channel region DT_ACT, a source electrode DT_S and a drain electrode DT_D of the driving transistor DT, and the first active pattern 62 may include channel regions ACT1-1 and ACT1-2, source electrodes S1-1 and S1-2, and drain electrodes D1-1 and D1-2 of the first first transistor ST1-1 and the second first transistor ST1-2.

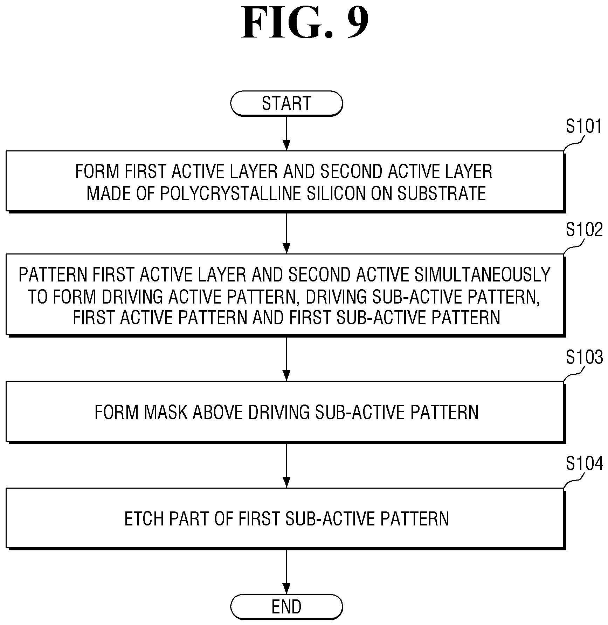

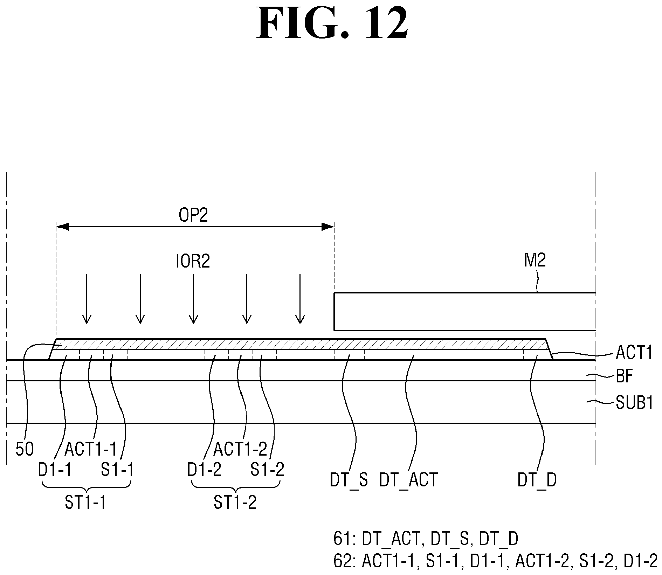

The driving active pattern 61 and the first active pattern 62 may include protrusions. The process of forming the protrusions B1 of the driving active pattern 61 and the protrusions B1 of the first active pattern 62 will be described later with reference to FIGS. 9 to 13B.

The protrusions B1 of the driving active pattern 61 and the first active pattern 62 may protrude toward the second active layer 50 with respect to the first active layer ACT1. The height of the protrusions B1 of the driving active pattern 61 and the first active pattern 62 may be in a range from about 50 angstrom (Å) to about 100 Å. In an embodiment where the driving active pattern 61 and the first active pattern 62 include or are made of polycrystalline silicon, the protrusions B1 of the driving active pattern 61 and the first active pattern 62 may be formed.

The second active layer 50 is disposed on the first active layer ACT1. The second active layer 50 may include a driving sub-active pattern 51 of the driving transistor DT and a first sub-active pattern 52 of the first transistor ST1.

The driving sub-active pattern 51 may be disposed or formed on the driving active pattern 61. The driving sub-active pattern 51 may overlap with the channel region DT_ACT of the driving transistor DT but not with the driving source electrode DT_S or the driving drain electrode DT_G. In addition, the thickness TH1 of the driving sub-active pattern 51 may be larger than the thickness of the driving active pattern 61. In an embodiment, for example, the thickness TH1 of the driving sub-active pattern 51 may be greater than or equal to about 20 Å and less than about 100 Å. The driving sub-active pattern 51 may include or be made of a material including amorphous silicon.

In an embodiment, as shown in FIG. 6, the driving sub-active pattern 51 may include protrusions. The protrusions A1 of the driving sub-active pattern 51 may protrude toward the gate insulator 130 with respect to the second active layer 50. The protrusions A1 of the driving sub-active pattern 51 may have the same size as the protrusions B1 of the driving active pattern 61 and the first active pattern 62. The height of the protrusions A1 of the driving sub-active pattern 51 may be in a range from about 50 Å to about 100 Å.

The first sub-active pattern 52 may be disposed or formed on the first active pattern 62. In one embodiment, the first sub-active pattern 52 may overlap with the channel regions ACT1-1 and ACT1-2 of the first first transistor ST2-1 and the second first transistor ST2-2 but not with the source electrode S2-1 and S2-2 and the drain electrodes D2-1 and D2-2. In addition, a thickness TH2 of the first sub-active pattern 52 may be smaller than the thickness of the first active pattern 62. In addition, the thickness TH2 of the first sub-active pattern 52 may be smaller than the thickness TH1 of the driving sub-active pattern 51. In an embodiment, for example, the thickness TH2 of the first sub-active pattern 52 may be less than about 20 Å.

In an embodiment, as shown in FIG. 7, the first sub-active pattern 52 may include protrusions. The protrusions A2 of the first sub-active pattern 52 may protrude toward the gate insulator 130 with respect to the second active layer 50. The protrusions A2 of the first sub-active pattern 52 may be smaller than the protrusions B1 of the driving active pattern 61 and the first active pattern 62. The height of the protrusions A2 of the first sub-active pattern 52 may be less than about 50 Å.

One end of the first sub-active pattern 52 may overlap with one end of the driving sub-active pattern 51. In an embodiment, for example, as shown in FIG. 5B, one end of the driving sub-active pattern 51 may overlap with one end of the first sub-active pattern 52 between the source electrode DT_S of the driving transistor DT and the source electrode S1-2 of the second first transistor ST1-2. The first sub-active pattern 52 may include or be made of a material different from that of the driving sub-active pattern 51. In an embodiment, for example, the first sub-active pattern 52 may be made of a material including amorphous silicon and hydrogen atoms bonded thereto.

Referring further to the graph in FIG. 8, the x-axis represents the voltage difference between the gate electrode DT_G and the source electrode DT_S of the driving transistor DT, and the y-axis represents the driving current Ids. The driving transistor DT has a driving voltage range for adjusting the luminance of the light-emitting element LE. The driving voltage range refers to a voltage range between the gate electrode DT_G and the source electrode DT_S of the driving transistor DT that allows the first driving current Ids1 to the second driving current Ids2 to flow. Although the first driving current Ids1 is $10^{-12}$ in the example shown in FIG. 8, the embodiments of the disclosure are not limited thereto.

The driving voltage range may be increased by the driving sub-active pattern 51 of the driving transistor DT. The driving sub-active pattern 51 serves to lower the electron mobility of the channel region DT_ACT of the driving transistor DT. The channel region DT_ACT of the driving transistor DT having the lowered electron mobility may decrease the amount of the driving current Ids versus the driving voltage. Therefore, if the driving sub-active pattern 51 of the driving transistor DT is not disposed, the driving transistor DT has a first driving voltage range DR1. In a case, where the driving sub-active pattern 51 of the driving transistor DT is disposed as in an embodiment of the invention, the driving transistor DT has a second driving voltage range DR2 that is wider than the first driving voltage range DR1. The second driving voltage range DR2 may be greater than the first driving voltage range DR1. In such a case, the driving voltage range for controlling the luminance of the light-emitting element LE may be increased. Accordingly, in an embodiment where the driving sub-active pattern 51 is disposed, the driving transistor DT is less affected by a change in the gate voltage Vg of the driving transistor DT due to the leakage current Ie, so that it is possible to prevent Mura and to improve image quality.

The active layer ACT may include the channel regions of the second to sixth transistors ST2 to ST6 as well as the source electrodes and drain electrodes thereof, in addition to those of the driving transistor DT and the first transistors ST1-1 and ST1-2.

The third to sixth transistors ST3 to ST6 may include third to sixth active patterns, respectively. The third to sixth active patterns may include channel regions, source electrodes and drain electrodes of the third to sixth transistors ST3 to ST6.

In an embodiment, no sub-active pattern may be disposed on the third to sixth active patterns. In such an embodiment, since the driving current Ids varies depending on the voltage of the gate electrode of the driving transistor DT, the leakage current Ie of the first transistor ST1 and the leakage current of the second transistor ST2 connected to the gate electrode of the driving transistor DT are reduced, so that the voltage change of the gate electrode of the driving transistor DT can be reduced. In such an embodiment, it may not be desired to reduce the leakage current of each of the third to sixth transistors ST3 to ST6 that are not directly connected to the gate electrode of the driving transistor DT, such that no sub-active pattern may be disposed on the third to sixth active patterns.

Referring back to FIG. 5A, the gate insulator 130 may be disposed or formed on the second active layer 50. The gate insulator 130 may be disposed or formed on the driving sub-active pattern 51 and the first sub-active pattern 52 of the active layer ACT. In addition, the gate insulator 130 may be disposed or formed on the third to sixth active patterns of the active layer ACT. In such an embodiment, the third to sixth active patterns and the gate insulator 130 may be in direct contact with each other. The gate insulator 130 may include or be formed of an inorganic layer, for example, a silicon nitride layer, a silicon oxynitride layer, a silicon oxide layer, a titanium oxide layer, or an aluminum oxide layer.

The first gate layer GTL1 may be disposed or formed on the gate insulator 130. The first gate layer GTL1 may include not only the gate electrodes DT_G1 and G1 to G6 of the driving transistor DT and the first to sixth switching transistors ST1 to ST6 but also a first electrode CE21 of the first capacitor C1, scan initialization lines GIL, scan write lines GWL, and emission lines EL. The first gate layer GTL1 may be defined by or made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

The interlayer dielectric film 141 may be disposed or formed over the first gate layer GTL1. The first interlayer dielectric film 141 may include or be formed of an inorganic layer, for example, a silicon nitride layer, a silicon oxynitride layer, a silicon oxide layer, a titanium oxide layer, or an aluminum oxide layer. The first interlayer dielectric film 141 may include a plurality of inorganic layers.

The second gate line GTL2 may be disposed or formed on the first interlayer dielectric film 141. The second gate layer GTL2 may include a second electrode CE22 of the first capacitor C1, an initializing voltage line VIL and a first first supply voltage line VDDL1. The second gate layer GTL2 may be defined by or made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

The second interlayer dielectric film 142 may be disposed or formed over the second gate layer GTL2. The second interlayer dielectric film 142 may include or be formed of an inorganic layer, for example, a silicon nitride layer, a silicon oxynitride layer, a silicon oxide layer, a titanium oxide layer, or an aluminum oxide layer. The second interlayer dielectric film 142 may include a plurality of inorganic layers.

The data metal layer DTL may be disposed or formed on the second interlayer dielectric film 142. The data metal layer DTL may include the data lines DL, the first supply voltage lines VDDL1, the second gate electrode DT_G2 of the driving transistor DT, the anode connection electrode ANDE, and the initialization voltage line VIL. The data gate electrode DTL may be defined by or made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

The planarization layer 160 may be disposed or formed on the data metal layer DTL to provide a flat surface over the level differences of the active layer ACT, the first gate layer GTL1, the second gate layer GTL2, and the data metal layer DTL. The planarization layer 160 may include or be formed of an organic layer such as an acryl resin, an epoxy resin, a phenolic resin, a polyamide resin and a polyimide resin.

The protective layer 150 may be further disposed or formed between the data metal layer DTL and the planarization layer 160. The protective layer 150 may include or be formed of an inorganic layer, for example, a silicon nitride layer, a silicon oxynitride layer, a silicon oxide layer, a titanium oxide layer, or an aluminum oxide layer.

In an embodiment, as shown in FIG. 5A, the driving transistor DT and the first to sixth transistors ST1 to ST6 may be implemented as top-gate transistors in which the gate electrode is located above the active layer, but the disclosure is not limited thereto. Alternatively, the driving transistor DT and the first to sixth transistors ST1 to ST6 may be implemented as bottom-gate transistors in which the gate electrode is located below the active layer ACT, or as double-gate transistors in which the gate electrodes are disposed above and below the active layer.

The first contact hole CNT1 may be a hole that penetrates or is defined through the first interlayer dielectric film 141 and the second interlayer dielectric film 142, via which the first gate electrode DT_G1 of the driving transistor DT is exposed as shown in FIG. 5A. The second gate electrode DT_G2 of the driving transistor DT may be connected to the first gate electrode DT_G1 of the driving transistor DT through the first contact hole CNT1.

The sixth contact hole CNT6 may be defined or formed through the gate insulator 130, the first interlayer dielectric film 141 and the second interlayer dielectric film 142, via which the second electrode D6 of the sixth transistor ST6 is exposed. The anode connection electrode ANDE may be connected to the second electrode D6 of the sixth transistor ST6 through the sixth contact hole CNT6.

An anode contact hole AND_CNT may be defined or formed through the protective layer 150 and the planarization layer 160, via which the anode connection electrode ANDE is exposed.

The emission material layer is disposed or formed on the planarization layer 160. The emission material layer includes a light-emitting element 170 and a bank 180.

The light-emitting element 170 and the pixel-defining film 180 are disposed or formed on the planarization layer 160. The light-emitting element 170 may include a first electrode 171, an organic emitting layer 172, and a second electrode 173.

The first electrode 171 may be formed on the planarization layer 160. The first electrode 171 may be connected to the anode connection electrode ANDE through the anode contact hole AND_CNT defined through the protective layer 150 and the planarization layer 160.

In an embodiment, where the light-emitting element 170 is a top-emission organic light-emitting diode that light exits from the organic emitting layer 172 toward the second electrode 173, the first electrode 171 may include or be made of a metal material having a high reflectivity such as a stack structure of aluminum and titanium (Ti / Al / Ti), a stack structure of aluminum and indium tin oxide (ITO) (i.e., ITO / Al / ITO), an APC alloy and a stack structure of the APC alloy and ITO (i.e., ITO / APC / ITO). The APC alloy is an alloy of silver (Ag), palladium (Pd) and copper (Cu).

The pixel-defining film 180 may be disposed or formed on the planarization layer160 to partition the first electrode 171 to define an emission area EA of each of the sub-pixels SP. The pixel-defining film 180 may be disposed or formed to cover the edge of the first electrode 171. The pixel-defining film 180 may include or be formed of an organic layer such as an acryl resin, an epoxy resin, a phenolic resin, a polyamide resin and a polyimide resin.

In the emission area EA of each of the sub-pixels SP, the first electrode 171, the organic emitting layer 172 and the second electrode 173 are stacked on one another in this order, so that holes from the first electrode 171 and electrons from the second electrode 173 are combined with each other in the organic emitting layer 172 to emit light.

The organic emitting layer 172 is disposed or formed on the first electrode 171 and the pixel-defining layer 180. The organic emitting layer 172 may include an organic material and emit light of a particular color. In an embodiment, for example, the organic emitting layer 172 may include a hole transporting layer, an organic material layer, and an electron transporting layer.

The organic emitting layer 172 of the sub-pixel SP may emit light of one of first to third colors. Alternatively, the organic emitting layer 172 of each of the sub-pixels SP may emit white light, and in which case, the sub-pixels SP may overlap the color filter layers of the first to third colors. The first color may be red, the second color may be green, and the third color may be blue. It is, however, to be understood that the disclosure is not limited thereto.

The second electrode 173 is disposed or formed on the organic emitting layer 172. The second electrode 173 may be formed to cover the organic emitting layer 172. The second electrode 173 may be a common layer formed across the sub-pixels SP1, SP2 and SP3. A capping layer may be disposed formed on the second electrode 173.

In an embodiment, where the light-emitting element 170 is the top-emission organic light-emitting diode, the second electrode 173 may include or be formed of a transparent conductive material (TCP) such as ITO and indium zinc oxide (IZO) that can transmit light, or a semi-transmissive conductive material such as magnesium (Mg), silver (Ag) and an alloy of magnesium (Mg) and silver (Ag). In an embodiment where the second electrode 173 includes or is formed of a semi-transmissive conductive material, the light extraction efficiency may be increased by using microcavities.

The encapsulation layer TFE may be disposed or formed on the light-emitting element layer EML. The encapsulation layer TFE may include at least one inorganic film to prevent permeation of oxygen or moisture into the emission material layer EML. In addition, the encapsulation layer TFE may include at least one organic film to protect the emission material layer EML from particles such as dust.

Alternatively, a second substrate may be disposed on the light-emitting element layer EML instead of the encapsulation layer TFE, such that the space between the light-emitting element layer EML and the second substrate may be empty or filled with a filling film. The filler film may be an epoxy filler film or a silicon filler film.

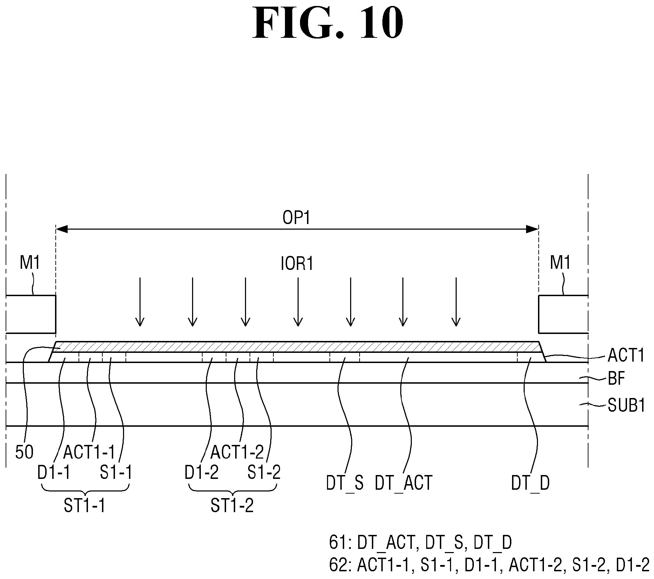

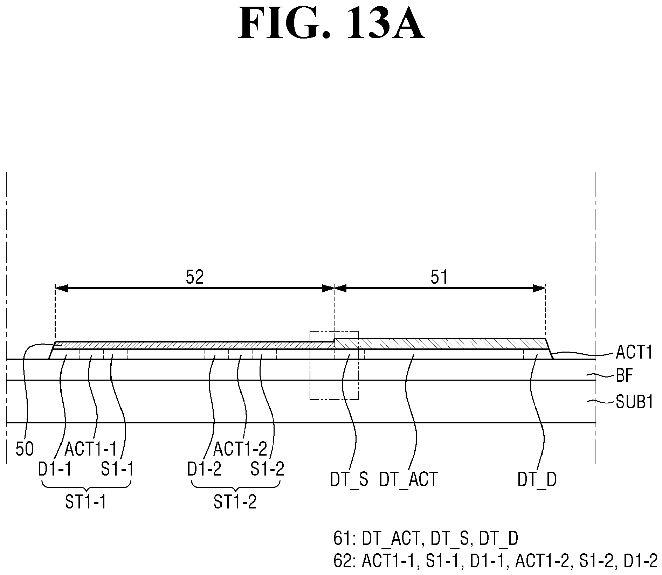

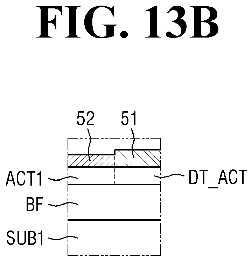

FIG. 9 is a flowchart for illustrating a method of fabricating a display device according to an embodiment of the disclosure. FIGS. 10 to 13B are cross-sectional views showing processes of a method of fabricating a display device according to an embodiment of the disclosure. Particularly, FIG. 13B is an enlarged view of the encircled area of FIG. 13A.

Referring to FIGS. 9 and 10, an active layer ACT is provided or formed on a substrate SUB (S101).

The active layer ACT includes a first active layer ACT1 and a second active layer 50. The first active layer ACT1 may be formed on the substrate SUB, and the second active layer 50 may be formed on the first active layer ACT1.

In an embodiment, an excimer laser annealing (ELA) process may be carried out on the first active layer ACT1 including amorphous silicon. The amorphous silicon of the first active layer ACT1 may be crystallized into polycrystalline silicon to form an aggregate of monocrystalline silicon. In such an embodiment, the protrusions B1 of the driving active pattern 61 and the protrusions B1 of the first active pattern 62 may be formed. The protrusions B1 of the driving active pattern 61 and the protrusions B1 of the first active pattern 62 may be grain boundaries which are generated as amorphous silicon is crystallized into polycrystalline silicon.

As the second active layer 50 is formed on the first active layer ACT1, protrusions A1 and A2 of the second active layer 50 may be formed. The protrusions A1 of the driving sub-active pattern 51 may be formed on the protrusions B1 of the driving active pattern 61. The protrusions A2 of the first sub-active pattern 52 may be formed on the protrusions B1 of the first active pattern 62. As will be described later, the height of the protrusions A2 of the first sub-active pattern 52 may be smaller than that of the protrusions A1 of the driving sub-active pattern 51.

In an embodiment, as described above, the first active layer ACT1 may include or be made of polycrystalline silicon or the like, and the second active layer 50 may include or be made of amorphous silicon or the like. The first active layer ACT1 and the second active layer 50 may be formed by, for example, chemical vapor deposition.

Subsequently, the first active layer ACT1 and the second active layer 50 may be simultaneously patterned (S102).

The first active layer ACT1 may form the driving active pattern 61 and the first active pattern 62 including or made of polysilicon. The second active layer 50 may form the driving sub-active pattern 51 and the first sub-active pattern 52 including or made of amorphous silicon.

The driving sub-active pattern 51 and the first sub-active pattern 52 may be formed using an open mask. In an embodiment, as shown in FIG. 10, a first mask M1 including a first opening OP1 defining a deposition area of the second active layer 50 is placed above the substrate SUB. The first opening OP1 of the first mask M1 may have a shape for exposing the active layers DT_ACT, ACT1-1 and ACT1-2, the source electrodes DT_S, S1-1 and S1-2 and the drain electrodes DT_D, D1-1 and D 1-2 of the driving transistor DT and the first transistors ST1-1 and ST1-2. Subsequently, a deposition process is carried out with the first mask M1, so that the driving sub-active pattern 51 and the first sub-active pattern 52 having a same shape as the first opening OP1 when viewed from the top may be formed on the substrate SUB.

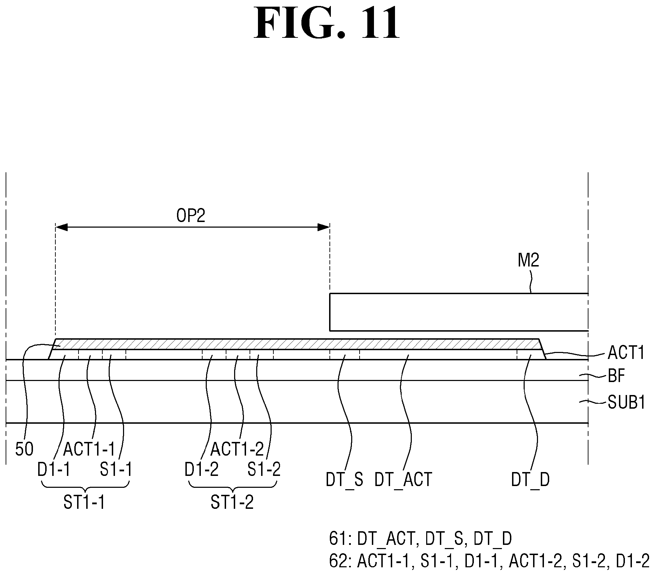

Subsequently, referring to FIGS. 9 and 11, a second mask M2 including a second opening OP2 is placed above the driving sub-active pattern 51 and the first sub-active pattern 52 (S103), and then the first sub-active pattern 52 is formed in the second active layer 50 (S104).

The first sub-active pattern 52 may be formed via a partial etching process using an etching material IOR2. The etching material IOR2 may be a gas containing hydrogen elements, such as HF. Alternatively, the etching material IOR2 may be, for example, a gas containing ammonium fluoride and hydrogen fluoride. It should be understood, however, that the disclosure is not limited thereto. The etching of the first sub-active pattern 52 may be carried out with any material as long as it has hydrophobic properties containing hydrogen elements. The first sub-active pattern 52 may be formed by, for example, plasma etching or wet etching through chemical vapor deposition.

The partial etching process may be carried out using an open mask. In an embodiment, as shown in FIG. 11, a second mask M2 including a second opening OP2 defining an etch target of the first sub-active pattern 52 is placed above the substrate SUB. The second opening OP2 of the second mask M2 may have a shape for exposing the active layers ACT1-1 and ACT1-2, the source electrodes S1-1 and S1-2 and the drain electrodes D1-1 and D1-2 of the first transistors ST1-1 and ST1-2. The channel region DT_ACT, the source electrode DT_S and the drain electrode DT_D of the driving transistor DT are masked by the second mask M2.

Subsequently, referring to FIGS. 9 to 13B, when a partial etching process is carried out with the second mask M2, the upper surface of the second active layer 50 exposed by the second opening OP2 is etched out. Herein, the partial etching process is carried out to remove the second active layer 50 only to a predetermined thickness rather than all of it. As a result, the first sub-active pattern 52 may have the thickness TH2 where it is in line with the second opening OP2.

In an embodiment, for example, the thickness TH2 of the first sub-active pattern 52 may be adjusted to have a value of about 20 Å or less. Incidentally, the driving sub-active pattern 51 is not substantially exposed by the etching material IOR2, the thickness of the driving sub-active pattern 51 remains substantially the same before and after the partial etching process.

The thickness TH1 of the driving sub-active pattern 51 may be different from the thickness TH2 of the first sub-active pattern 52. In an embodiment, referring back to FIG. 5B, the thickness TH1 of the driving sub-active pattern 51 may be in a range from about 20 Å to about 200 Å, while the thickness TH2 of the first sub-active pattern 52 may be equal to or less than about 20 Å via the partial etching process.

The protrusions A2 of the first sub-active pattern 52 may be etched by the partial etching process. Accordingly, after the partial etching process has been carried out, the height of the protrusions A2 of the first sub-active pattern 52 may be smaller than that of the protrusions A1 of the driving sub-active pattern 51.

When the partial etching process is performed, the driving sub-active pattern 51 and the first sub-active pattern 52 having the same shape as the first opening OP1 when viewed from the top is formed on the substrate SUB, to form the display device 1.

In the foregoing description, the partial etching process is carried out as a process of removing the second active layer 50 only to a predetermined thickness. It should be understood, however, that the disclosure is not limited thereto. The partial etching process may be carried out to remove the second active layer 50 entirely. In an embodiment, for example, when a partial etching process is carried out, the entire second active layer 50 exposed by the second opening OP2 may be etched out.

According to an embodiment, by forming the sub-active pattern on at least some of the transistors including polycrystalline semiconductor included in the pixel, the leakage current Ie may be suppressed below a certain level. Therefore, it is possible to prevent the display luminance from decreasing even if the display device is driven with a low frame frequency when displaying a still image to reduce power consumption, and thus flicking is not recognized.

In such an embodiment, by forming the driving sub-active pattern 51 of the driving transistors DT including polycrystalline semiconductor included in the pixel, the driving voltage range DR2 of the driving transistor DT may be increased, thereby preventing Mura and improving image quality.

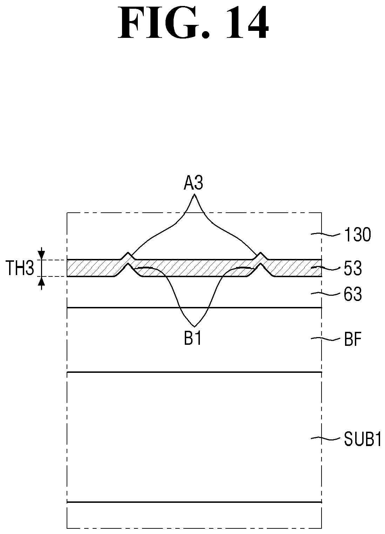

FIG. 14 is a cross-sectional view showing a second transistor according to an alternative embodiment.

The embodiment of FIG. 14 is substantially the same as the embodiment of FIGS. 5 to 13B except for a second sub-active pattern 53 of a second transistor ST2; and, therefore, any repetitive detailed descriptions of the same or like elements as those described above will be omitted.

The second transistor ST2 may be implemented as a dual transistor of a first second transistor ST2-1 and a second second transistor ST2-2. The first second transistor ST2-1 and the second second transistor ST2-2 may be control connection between the gate electrode DT_G of the driving transistor DT and the initialization voltage line VIL that applies the initialization voltage in response to an initialization scan signal of an initialization scan line GI.

The active layer ACT includes a second active pattern 63 of the second-first transistor ST2-1 and the second-second transistor ST2-2, and a second sub-active pattern 53.

Referring to FIG. 14, when the second active pattern 63 include or is made of polycrystalline silicon and is doped with ions, the ion-doped second active pattern 63 may have conductivity. By doing so, the second active pattern 63 may include channel regions, source electrode and drain electrodes of the first second transistor ST2-1 and the second second transistor ST2-2.

The second sub-active pattern 53 may be disposed or formed on the second active pattern 63. The second sub-active pattern 53 may overlap with the channel regions of the first second transistor ST2-1 and the second second transistor ST2-2 but not with the source electrode and the drain electrodes. In addition, a thickness TH3 of the second sub-active pattern 53 may be smaller than the thickness of the second active pattern 63. In addition, the thickness TH3 of the second sub-active pattern 53 may be substantially equal to the thickness TH2 of the first sub-active pattern 62. In such an embodiment, the thickness TH3 of the second sub-active pattern 53 may be smaller than the thickness TH1 of the driving sub-active pattern 51. In an embodiment, for example, the thickness TH3 of the second sub-active pattern 53 may be less than about 20 Å.

The method of fabricating the second sub-active pattern 53 is substantially to the same as that of the first sub-active pattern 52; and, therefore, any repetitive detailed descriptions thereof will be omitted.

Also in such an embodiment, by forming the driving sub-active pattern 51 of the driving transistors DT including polycrystalline semiconductor included in the pixel, the driving voltage range DR2 of the driving transistor DT may be increased, thereby preventing Mura and improving image quality.

In such an embodiment, when the display device is driven with the second frame frequency, by forming the sub-active pattern 52 and 53 on the first and second transistors ST1 and ST2 including the polycrystalline semiconductor included in the pixel, the leakage current Ie may be suppressed below a certain level. Therefore, it is possible to prevent the display luminance from decreasing, and thus flicking is not recognized.

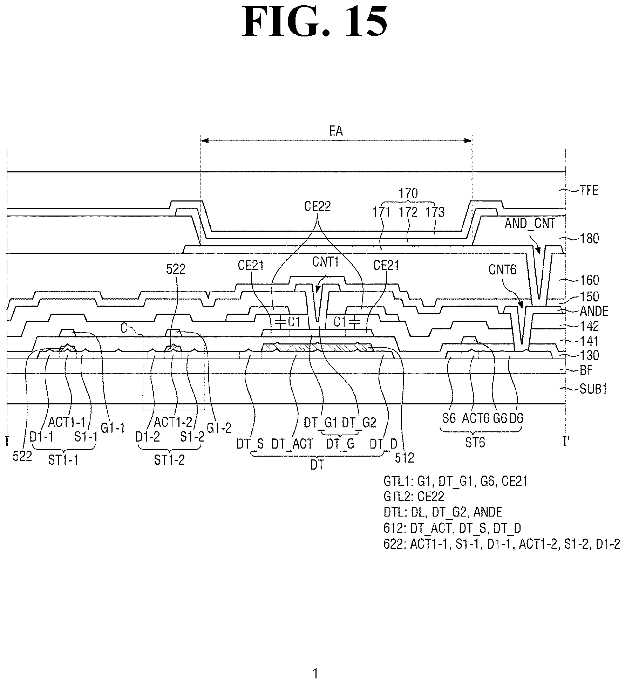

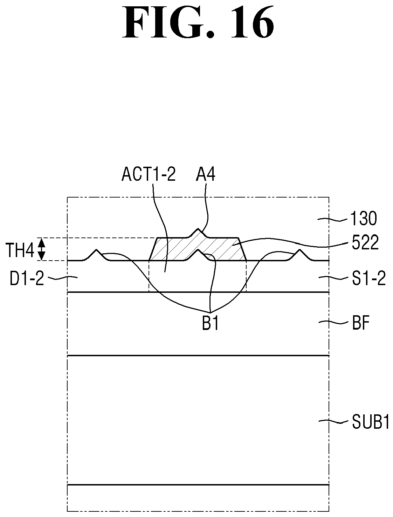

FIG. 15 is a cross-sectional view showing a driving transistor, a first transistor and a sixth transistor according to an alternative embodiment. FIG. 16 is an enlarged, cross-sectional view of area C of FIG. 15.

The embodiment of FIGS. 15 and 16 is substantially the same as the embodiment of FIGS. 5 to 13B except for a driving sub-active pattern 512 of a driving transistor DT and a first sub-active pattern 522 of a first transistor ST1; and, therefore, any repetitive detailed descriptions of the same or like elements as those described above will be omitted.

Referring to FIGS. 15 and 16, the active layer ACT includes a driving active pattern 612 and a driving sub-active pattern 512 of the driving transistor DT, and a first active pattern 622 and a first sub-active pattern 522 of the first transistor ST1.

In an embodiment, where the driving active pattern 612 and the first active pattern 622 include or are made of polycrystalline silicon, and the driving active pattern 612 and the first active pattern 622 are doped with ions, the ion-doped driving active pattern 612 and the first active pattern 622 may have conductivity. Accordingly, the driving active pattern 612 may include a channel region DT_ACT, a source electrode DT_S and a drain electrode DT_D of the driving transistor DT, and the first active pattern 622 may include channel regions ACT1-1 and ACT1-2, source electrodes S1-1 and S1-2, and drain electrodes D1-1 and D1-2 of the first first transistor ST1-1 and the second first transistor ST1-2.

The driving sub-active pattern 512 may be disposed or formed on the channel region DT_ACT of the driving active pattern 612. The driving sub-active pattern 512 may overlap with the channel region DT_ACT of the driving transistor DT but not with the driving source electrode DT_S or the driving drain electrode DT_G. In addition, the driving sub-active pattern 512 may overlap the gate electrode DT_G of the driving transistor DT.

The thickness of the driving sub-active pattern 512 may be larger than the thickness of the driving active pattern 612. In an embodiment, for example, the thickness of the driving sub-active pattern 512 may be greater than or equal to about 20 Å and less than about 100 Å. The driving sub-active pattern 512 may include or be made of a material including amorphous silicon.

The first sub-active pattern 522 may be disposed or formed on each of the channel regions ACT1-1 and ACT1-2 of the first active pattern 622. The first sub-active pattern 522 may overlap with the channel regions ACT1-1 and ACT1-2 of the first first transistor ST1-1 and the second first transistor ST1-2 but not with the source electrode S1-2 and S2-2 and the drain electrodes D1-2 and D2-2 thereof. In addition, the first sub-active pattern 522 may overlap with each of the gate electrodes G1-1 and G1-2 of the first first transistor ST1-1 and the second first transistor ST1-2.

A thickness TH4 of the first sub-active pattern 522 may be smaller than the thickness of the first active pattern 622. In addition, the thickness TH4 of the first sub-active pattern 522 may be smaller than the thickness of the driving sub-active pattern 512. In an embodiment, for example, the thickness TH4 of the first sub-active pattern 522 may be less than about 20 Å. The first sub-active pattern 522 may include or be made of a material different from that of the driving sub-active pattern 512. In an embodiment, for example, the first sub-active pattern 522 may include or be made of a material including amorphous silicon and hydrogen atoms bonded thereto.

Also in such an embodiment, when the display device is driven with the second frame frequency, by forming the sub-active pattern 52 on at least some of the transistors including the polycrystalline semiconductor included in the pixel, the leakage current Ie can be suppressed below a certain level. Therefore, it is possible to prevent the display luminance from decreasing, and thus flicking is not recognized.

In such an embodiment, by forming the driving sub-active pattern 512 of the driving transistors DT including polycrystalline semiconductor included in the pixel, the driving voltage range DR2 of the driving transistor DT may be increased, thereby preventing Mura and improving image quality.

In such an embodiment, the driving sub-active pattern 512 is formed on the channel region DT_ACT of the driving transistor DT, so that each of the source electrode DT_S and the drain electrode DT_D of the driving transistor DT does not overlap with the driving sub-active pattern 512. In addition, the first sub-active pattern 522 is formed on each of the channel regions ACT1-1 and ACT1-2 of the first transistor ST1, so that each of the source electrodes S1-1 and S1-2 and the drain electrodes D1-1 and D1-2 of the first transistor ST1 does not overlap the first sub-active pattern 522. Accordingly, when the driving active pattern 612 and the first active pattern 622 are doped with ions, the source electrode DT_S, the drain electrode DT_D of the driving transistor DT, and the source electrodes S1-1 and S1-2 and the drain electrodes D1-1 and D1-2 of the first transistor ST1 may be doped more efficiently.

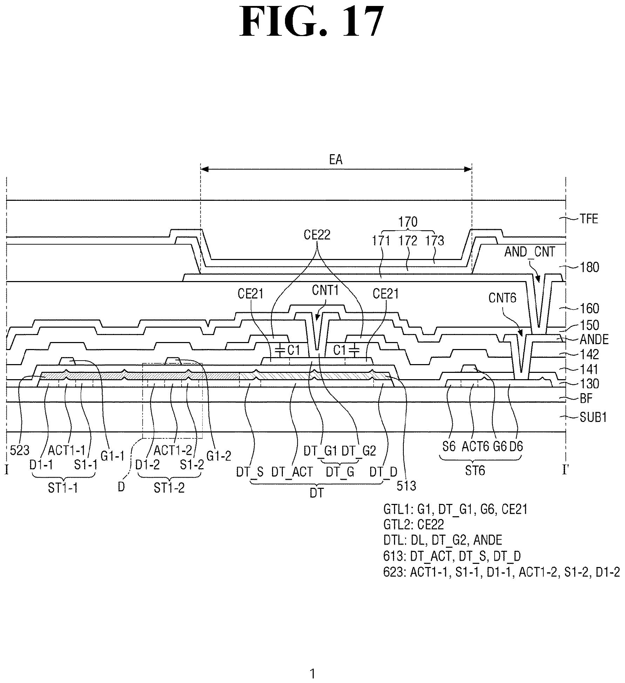

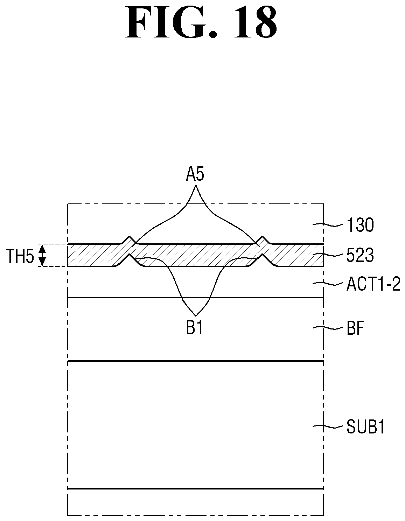

FIG. 17 is a cross-sectional view showing a driving transistor, a first transistor and a sixth transistor according to an alternative embodiment. FIG. 18 is an enlarged cross-sectional view of area D of FIG. 17.

The embodiment of FIGS. 17 and 18 is substantially to the same as the embodiment of FIGS. 5 to 13B except for a first sub-active pattern 523 of a first transistor ST1; and, therefore, any repetitive detailed descriptions of the same or like elements as those described above will be omitted.

Referring to FIGS. 17 and 18, the active layer ACT includes a driving active pattern 613 and a driving sub-active pattern 513 of the driving transistor DT, and a first active pattern 623 and a first sub-active pattern 523 of the first transistor ST1.

In an embodiment where the first active pattern 623 include or is made of polycrystalline silicon and is doped with ions, the ion-doped first active pattern 623 may have conductivity. By doing so, the first active pattern 623 may include channel regions ACT1-1 and ACT1-2, source electrode S1-1 and S1-2 and drain electrodes D1-1 and D1-2 of the first first transistor ST1-1 and the second first transistor ST1-2.

The first sub-active pattern 523 may be disposed or formed on the first active pattern 623. The first sub-active pattern 523 may overlap with the channel regions ACT1-1 and ACT1-2 of the first first transistor ST1-1 and the second first transistor ST1-2 but not with the source electrode S2-1 and S2-2 and the drain electrodes D2-1 and D2-2. In addition, a thickness TH5 of the first sub-active pattern 523 may be smaller than the thickness of the first active pattern 623. In addition, the thickness TH5 of the first sub-active pattern 523 may be equal to the thickness of the driving sub-active pattern 513. In an embodiment, for example, the thickness TH2 of the first sub-active pattern 523 may be in a range from about 20 Å to about 200 Å.

One end of the first sub-active pattern 523 may overlap with one end of the driving sub-active pattern 513. In an embodiment, for example, as shown in FIG. 17, one end of the driving sub-active pattern 513 may overlap with one end of the first sub-active pattern 523 between the source electrode DT_S of the driving transistor DT and the source electrode S2 of the second first transistor ST1-2. The first sub-active pattern 523 may include or be made of a material different from that of the driving sub-active pattern 513. In an embodiment, for example, the first sub-active pattern 523 may include or be made of a material including amorphous silicon and hydrogen atoms bonded thereto.

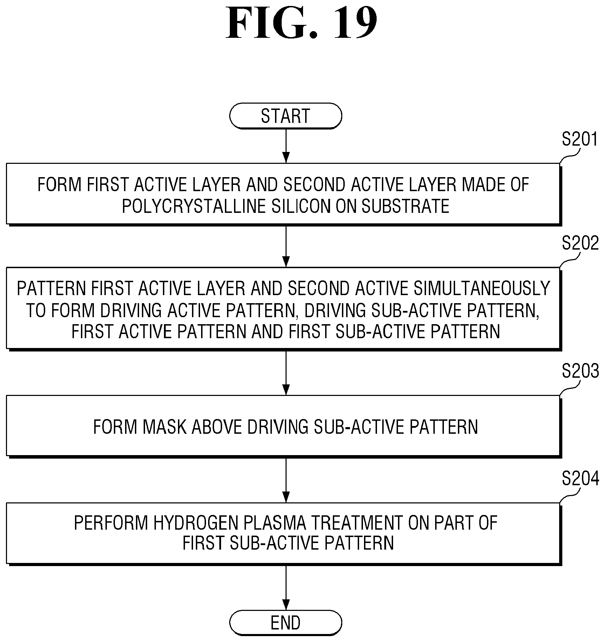

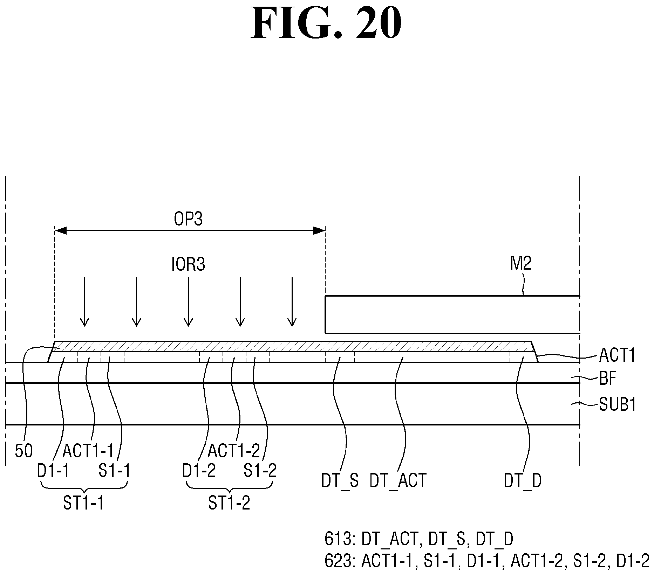

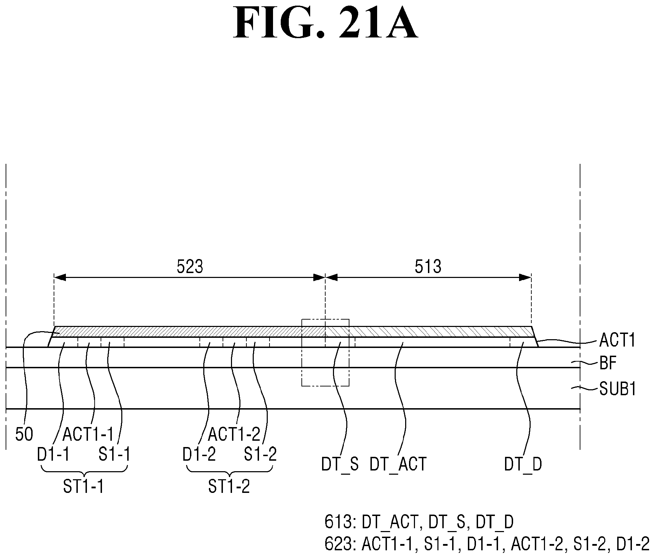

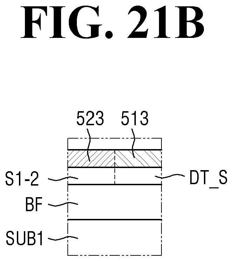

FIG. 19 is a flowchart for illustrating a method of fabricating a display device according to an alternative embodiment of the disclosure. FIGS. 20 to 21B are cross-sectional views for illustrating a method of fabricating a display device according to an alternative embodiment of the disclosure. Particularly, FIG. 21B is an enlarged view of the encircled area of the FIG. 21A.

The embodiment of FIGS. 19 to 21B is substantially to the same as the embodiment of FIGS. 9 to 13B except that a first sub-active pattern 523 is subjected to hydrogen plasma treatment; and, therefore, any repetitive detailed descriptions of the same or like elements as those described above will be omitted.

Referring to FIG. 19, initially, an active layer ACT may be provided or formed on the substrate SUB (S201), and a first active layer ACT1 and a second active layer 50 may be simultaneously patterned (S202). Subsequently, a second mask M2 including a second opening OP2 may be placed above a driving sub-active pattern 513 and a first sub-active pattern 523 (S203). Process S203 is substantially identical to process S103 described above with reference to the embodiment of FIGS. 9 to 13B; and, therefore, the redundant descriptions will be omitted.

Referring to FIGS. 19 to 21B, lastly, hydrogen plasma treatment is performed on the region of the first sub-active pattern 523 (S204).

The first sub-active pattern 523 may be formed via a partial plasma treatment process using a treatment material IOR3. The treatment material IOR3 may be a gas containing hydrogen elements, such as $H_2$. It should be understood, however, that the disclosure is not limited thereto. The first sub-active pattern 523 may be carried out with any material as long as it has hydrophobic properties containing hydrogen elements. The first sub-active pattern 523 may be formed by, for example, plasma treatment through chemical vapor deposition.

The partial plasma treatment process may be carried out using an open mask. Specifically, as shown in FIG. 20, a second mask M2 including a third opening OP3 defining an etch target of the first sub-active pattern 523 is placed above the substrate SUB. The third opening OP3 of the second mask M2 may have a shape for exposing the active layers ACT1-1 and ACT1-2, the source electrodes S1-1 and S1-2 and the drain electrodes D1-1 and D1-2 of the second transistors ST2-1 and ST2-2. The channel region DT_ACT, the source electrode DT_S and the drain electrode DT_D of the driving transistor DT are masked by the second mask M2.

Subsequently, referring to FIGS. 19 and 21A, when a partial plasma process is carried out with the second mask M2, a hydrogen plasma is injected onto the upper surface of the second active layer 50 exposed by the third open part OP3. Accordingly, as shown in FIG. 21B, the first sub-active pattern 523 may include or be made of a material including amorphous silicon and hydrogen atoms bonded thereto.

Incidentally, the driving sub-active pattern 513 is not substantially exposed by the treatment material IOR3, the thickness of the driving sub-active pattern 513 remains substantially the same before and after the partial plasma treatment process. The thickness of the driving sub-active pattern 513 may be equal to the thickness of the first sub-active pattern 523. In an embodiment, for example, the thickness of the first sub-active pattern 523 may be in a range from about 20 Å to about 200 Å.

In an embodiment when the partial plasma treatment is performed, the driving sub-active pattern 513 and the first sub-active pattern 523 having the same shape as the first opening OP1 when viewed from the top is formed on the substrate SUB, to form the display device 1.

Also in such an embodiment, by forming the first sub-active pattern 523 subjected to the hydrogen plasma treatment on the first transistor ST1, it is possible to suppress the leakage current Ie below a certain level, as in described above. In such an embodiment, even when the display device is driven at a low frame frequency to reduce power consumption when displaying a still image, the display luminance does not decrease and thus flickering is not recognized.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

Further embodiments are set out in the following Numbered Paragraphs (NPs):

NP1. A display device comprising:

a substrate;
a first active layer comprising a driving active pattern of a driving transistor disposed on the substrate and a first active pattern of a first transistor disposed on the substrate;
a second active layer comprising a driving sub-active pattern disposed on the driving active pattern of the first active layer;
a first insulating film disposed on the first active layer and the second active layer;
a driving gate electrode disposed on the first insulating film and overlapping the driving sub-active pattern; and
a first gate electrode disposed on the first insulating film and overlapping the first active pattern,
wherein a thickness of the driving active pattern is greater than a thickness of the driving sub-active pattern.

NP2. The display device of NP1,

wherein the second active layer further comprises a first sub-active pattern disposed on the first active pattern, and
a thickness of the first active pattern is greater than a thickness of the first sub-active pattern.

NP3. The display device of NP2,
wherein the thickness of the driving sub-active pattern is smaller than the thickness of the first sub-active pattern.

NP4. The display device of NP2,
wherein the thickness of the first sub-active pattern is less than about 20 Å.

NP5. The display device of NP2,
wherein the thickness of the driving sub-active pattern is greater than or equal to about 20 Å and less than about 100 Å.

NP6. The display device of NP2,

wherein the first active layer comprises polycrystalline silicon,
wherein the driving sub-active pattern comprises amorphous silicon, and
the first sub-active pattern comprises the amorphous silicon and hydrogen atoms bonded thereto.

NP7. The display device of NP2,

wherein the first active pattern comprises a first channel, a first source electrode and a first drain electrode, and
the first sub-active pattern overlaps with the first channel but not with the first source electrode or the first drain electrode.

NP8. The display device of NP1,

wherein the driving active pattern comprises a driving channel, a driving source electrode, and a driving drain electrode, and
the driving sub-active pattern overlaps with the driving channel and does not overlap with the driving source electrode and the driving drain electrode.

NP9. The display device of NP2,

wherein the driving sub-active pattern comprises first protrusions protruding from an upper surface thereof,
the first sub-active pattern comprises second protrusions protruding from an upper surface thereof, and
wherein a height of the second protrusions is smaller than a height of the first protrusion.

NP10. The display device of NP9,

wherein the first active pattern comprises third protrusions protruding from an upper surface thereof, and
the height of the second protrusion is smaller than a height of the third protrusions.

NP11. A display device comprising:

a write scan line from which a write scan signal is applied; and
a sub-pixel connected to the write scan line, wherein the sub-pixel comprises

a light-emitting element;
a driving transistor which provides a driving current flowing to the light-emitting element in response to a voltage of a gate electrode; and
a first transistor which controls a connection between the gate electrode and a first electrode of the driving transistor in response to the write scan signal from the write scan line, and

wherein the first transistor comprises a first active pattern comprising a first material, and a first sub-active pattern disposed on the first active pattern and comprising a second material different from the first material, and
wherein a thickness of the first active pattern is greater than a thickness of the first sub-active pattern.

NP12. The display device of NP11,

wherein the driving transistor comprises a driving active pattern comprising the first material, and a driving sub-active pattern disposed on the driving active pattern and comprising a third material different from the first material and the second material, and
wherein a thickness of the driving sub-active pattern is greater than the thickness of the first sub-active pattern.

NP13. The display device of NP12,

wherein the first material comprises polycrystalline silicon,
wherein the second material comprises amorphous silicon and hydrogen atoms bonded thereto, and
the third material comprises the amorphous silicon.

NP14. The display device of NP12, further comprising:

an initialization scan line from which an initialization scan signal is applied; and

a second transistor which controls a connection between the gate electrode of the driving transistor and an initialization voltage line from which an initialization voltage is applied in response to the initialization scan signal of the initialization scan line,

wherein the second transistor comprises a second active pattern comprising a first material and a second sub-active pattern disposed on the second active pattern and comprising the second material.

NP15. The display device of NP14,
wherein a thickness of the driving sub-active pattern is smaller than a thickness of the second sub-active pattern.

NP16. The display device of NP15,
wherein the thickness of the second sub-active pattern is less than about 20 Å.

NP17. The display device of NP14, further comprising:

a data line from which a data voltage is applied; and
a third transistor which controls a connection between the data line and a second electrode of the driving transistor in response to the write scan signal of the write scan line,
wherein the third transistor comprises a third active pattern comprising the first material and an insulating film disposed on the third active pattern, and
wherein the third active pattern is in contact with the insulating film.

NP18. The display device of NP 11, further comprising:

a data line from which a data voltage is applied; and
a timing controller which controls drivers in a way such that the write scan signal and the data voltage are supplied at a frame frequency of 60 Hz or higher in a first driving mode, and the write scan signal and the data voltage are supplied at a frame frequency of less than 60 Hz in a second driving mode.

NP19. A method of fabricating a display device, the method comprising:

providing a first active layer comprising polycrystalline silicon on a substrate;
providing a second active layer comprising amorphous silicon on the first active layer;
patterning the first active layer and the second active layer simultaneously to form a driving active pattern comprising the polycrystalline silicon, a driving sub-active pattern comprising the amorphous silicon, a first active pattern comprising the polycrystalline silicon and a first sub-active pattern comprising the amorphous silicon;
disposing a mask above the driving sub-active pattern; and
etching a part of the first sub-active pattern.

NP20. The method of NP19, further comprising:
performing hydrogen plasma treatment on the first sub-active pattern.

**Claims**

1. A display device comprising:

a substrate;
a first active layer comprising a driving active pattern of a driving transistor disposed on the substrate and a first active pattern of a first transistor disposed on the substrate;
a second active layer comprising a driving sub-active pattern disposed on the driving active pattern of the first active layer;
a first insulating film disposed on the first active layer and the second active layer;
a driving gate electrode disposed on the first insulating film and overlapping the driving sub-active pattern; and
a first gate electrode disposed on the first insulating film and overlapping the first active pattern,
wherein a thickness of the driving active pattern is greater than a thickness of the driving sub-active pattern.

2. The display device of claim 1,

wherein the second active layer further comprises a first sub-active pattern disposed on the first active pattern, and
a thickness of the first active pattern is greater than a thickness of the first sub-active pattern.

3. The display device of claim 2,
wherein the thickness of the driving sub-active pattern is larger than the thickness of the first sub-active pattern.

4. The display device of claim 2 or claim 3,

wherein the thickness of the first sub-active pattern is less than about 20 Å; and/or
wherein the thickness of the driving sub-active pattern is greater than or equal to about 20 Å and less than about 100 Å.

5. The display device of any one of claims 2-4,

wherein the first active layer comprises polycrystalline silicon,
wherein the driving sub-active pattern comprises amorphous silicon, and
the first sub-active pattern comprises the amorphous silicon and hydrogen atoms bonded thereto.

6. The display device of any one of claims 2-5,

wherein the first active pattern comprises a first channel, a first source electrode and a first drain electrode, and
the first sub-active pattern overlaps with the first channel but not with the first source electrode or the first drain electrode.

7. The display device of any preceding claim,

wherein the driving active pattern comprises a driving channel, a driving source electrode, and a driving drain electrode, and
the driving sub-active pattern overlaps with the driving channel and does not overlap with the driving source electrode and the driving drain electrode.

8. The display device of any one of claims 2-7,

wherein the driving sub-active pattern comprises first protrusions protruding from an upper surface thereof,
the first sub-active pattern comprises second protrusions protruding from an upper surface thereof, and
wherein a height of the second protrusions is smaller than a height of the first protrusion
wherein, optionally, the first active pattern comprises third protrusions protruding from an upper surface thereof, and
the height of the second protrusion is smaller than a height of the third protrusions.

9. The display device of any one of claims 2-8, comprising:

a write scan line from which a write scan signal is applied; and
a sub-pixel connected to the write scan line, wherein the sub-pixel comprises:

a light-emitting element;
the driving transistor, wherein the driving transistor provides a driving current flowing to the light-emitting element in response to a voltage of a gate electrode; and
the first transistor, wherein the first transistor controls a connection between the gate electrode and a first electrode of the driving transistor in response to the write scan signal from the write scan line, and

wherein the first active pattern comprises a first material, and the first sub-active pattern comprises a second material different from the first material,
wherein, optionally, the driving active pattern comprises the first material, and the driving sub-active pattern comprises a third material different from the first material and the second material.

10. The display device of claim 9, further comprising:

an initialization scan line from which an initialization scan signal is applied; and
a second transistor which controls a connection between the gate electrode of the driving transistor and an initialization voltage line from which an initialization voltage is applied in response to the initialization scan signal of the initialization scan line,
wherein the second transistor comprises a second active pattern comprising the first material and a second sub-active pattern disposed on the second active pattern and comprising the second material.

11. The display device of claim 10,

wherein a thickness of the driving sub-active pattern is greater than a thickness of the second sub-active pattern,
wherein, optionally, the thickness of the second sub-active pattern is less than about 20 Å.

12. The display device of claim 10 or claim 11, further comprising:

a data line from which a data voltage is applied; and
a third transistor which controls a connection between the data line and a second electrode of the driving transistor in response to the write scan signal of the write scan line,
wherein the third transistor comprises a third active pattern comprising the first material and an insulating film disposed on the third active pattern, and
wherein the third active pattern is in contact with the insulating film.

13. The display device of any one of claims 9 - 12, further comprising:

a data line from which a data voltage is applied; and
a timing controller which controls drivers in a way such that the write scan signal and the data voltage are supplied at a frame frequency of 60 Hz or higher in a first driving mode, and the write scan signal and the data voltage are supplied at a frame frequency of less than 60 Hz in a second driving mode.

14. A method of fabricating a display device, the method comprising:

providing a first active layer comprising polycrystalline silicon on a substrate;
providing a second active layer comprising amorphous silicon on the first active layer;
patterning the first active layer and the second active layer simultaneously to form a driving active pattern comprising the polycrystalline silicon, a driving sub-active pattern comprising the amorphous silicon, a first active pattern comprising the polycrystalline silicon and a first sub-active pattern comprising the amorphous silicon;
disposing a mask above the driving sub-active pattern; and etching a part of the first sub-active pattern.

15. The method of claim 14, further comprising:
performing hydrogen plasma treatment on the first sub-active pattern.

# FIG. 1

EP 4 235 789 A1

# FIG. 2

# FIG. 3

# FIG. 4

# FIG. 5A

EA

TFE

170
171 172 173

CE22

AND_CNT

180

CE21 CNT1 CE21 CNT6
160
150
ANDE
142
141
130
BF
SUB1

B
$\mp$C1 C1$\mp$

A

52 ACT1-1 G1-1 ACT1-2 G1-2 DT_G1 DT_G2 S6 ACT6 G6 D6
D1-1 S1-1 D1-2 S1-2 DT_S DT_ACT DT_G DT_D ST6
ST1-1 ST1-2 DT 51
I I'

GTL1: G1, DT_G1, G6, CE21
GTL2: CE22
DTL: DL, DT_G2, ANDE
61: DT_ACT, DT_S, DT_D
62: ACT1-1, S1-1, D1-1, ACT1-2, S1-2, D1-2
50: 51, 52
ACT1: 61, 62
ACT: ACT1, 50

EP 4 235 789 A1

1

# FIG. 5B

# FIG. 6

# FIG. 7

# FIG. 8

# FIG. 9

```
          ( START )
                │
                ▼                                    S101
┌─────────────────────────────────────────┐
│   FORM FIRST ACTIVE LAYER AND SECOND ACTIVE LAYER   │
│   MADE OF POLYCRYSTALLINE SILICON ON SUBSTRATE      │
└─────────────────────────────────────────┘
                │
                ▼                                    S102
┌─────────────────────────────────────────┐
│ PATTERN FIRST ACTIVE LAYER AND SECOND ACTIVE SIMULTANEOUSLY │
│  TO FORM DRIVING ACTIVE PATTERN, DRIVING SUB-ACTIVE PATTERN, │
│   FIRST ACTIVE PATTERN AND FIRST SUB-ACTIVE PATTERN  │
└─────────────────────────────────────────┘
                │
                ▼                                    S103
┌─────────────────────────────────────────┐
│      FORM MASK ABOVE DRIVING SUB-ACTIVE PATTERN     │
└─────────────────────────────────────────┘
                │
                ▼                                    S104
┌─────────────────────────────────────────┐
│        ETCH PART OF FIRST SUB-ACTIVE PATTERN        │
└─────────────────────────────────────────┘
                │
                ▼
             ( END )
```

# FIG. 10

61: DT_ACT, DT_S, DT_D
62: ACT1-1, S1-1, D1-1, ACT1-2, S1-2, D1-2

# FIG. 11

OP2

M2

ACT1

BF

SUB1

50

ACT1-1

D1-1  S1-1

ACT1-2

D1-2  S1-2

DT_S  DT_ACT

DT_D

ST1-1

ST1-2

61: DT_ACT, DT_S, DT_D
62: ACT1-1, S1-1, D1-1, ACT1-2, S1-2, D1-2

# FIG. 12

OP2

IOR2

M2

ACT1

BF

SUB1

50  ACT1-1  ACT1-2
D1-1  S1-1   D1-2  S1-2   DT_S  DT_ACT   DT_D

ST1-1      ST1-2

61: DT_ACT, DT_S, DT_D
62: ACT1-1, S1-1, D1-1, ACT1-2, S1-2, D1-2

# FIG. 13A

52     51

ACT1
BF
SUB1

50
D1-1   ACT1-1   S1-1
ST1-1

D1-2   ACT1-2   S1-2
ST1-2

DT_S   DT_ACT     DT_D

61: DT_ACT, DT_S, DT_D
62: ACT1-1, S1-1, D1-1, ACT1-2, S1-2, D1-2

# FIG. 13B

52    51

ACT1 ⌇             DT_ACT

BF ⌇

SUB1 ⌇

# FIG. 14

A3

TH3

130

53

63

B1

BF

SUB1

FIG. 15

# FIG. 16

ACT1-2   A4

130

522

TH4

D1-2

S1-2

B1

BF

SUB1

# FIG. 17

EP 4 235 789 A1

GTL1: G1, DT_G1, G6, CE21
GTL2: CE22
DTL: DL, DT_G2, ANDE
613: DT_ACT, DT_S, DT_D
623: ACT1-1, S1-1, D1-1, ACT1-2, S1-2, D1-2

# FIG. 18

# FIG. 19

```
                    ┌─────────────┐
                    │    START    │
                    └──────┬──────┘
                           │                        S201
┌──────────────────────────────────────────────────┐
│   FORM FIRST ACTIVE LAYER AND SECOND ACTIVE        │
│   LAYER MADE OF POLYCRYSTALLINE SILICON ON         │
│   SUBSTRATE                                        │
└──────────────────────────┬─────────────────────────┘
                           │                        S202
┌──────────────────────────────────────────────────┐
│  PATTERN FIRST ACTIVE LAYER AND SECOND ACTIVE      │
│  SIMULTANEOUSLY TO FORM DRIVING ACTIVE PATTERN,    │
│  DRIVING SUB-ACTIVE PATTERN, FIRST ACTIVE          │
│  PATTERN AND FIRST SUB-ACTIVE PATTERN              │
└──────────────────────────┬─────────────────────────┘
                           │                        S203
┌──────────────────────────────────────────────────┐
│   FORM MASK ABOVE DRIVING SUB-ACTIVE PATTERN       │
└──────────────────────────┬─────────────────────────┘
                           │                        S204
┌──────────────────────────────────────────────────┐
│   PERFORM HYDROGEN PLASMA TREATMENT ON PART        │
│   OF FIRST SUB-ACTIVE PATTERN                      │
└──────────────────────────┬─────────────────────────┘
                           │
                    ┌──────┴──────┐
                    │     END     │
                    └─────────────┘
```

# FIG. 20

OP3

IOR3

M2

ACT1

BF

SUB1

50

ACT1-1

D1-1    S1-1

ACT1-2

D1-2    S1-2

DT_S   DT_ACT

DT_D

ST1-1

ST1-2

613: DT_ACT, DT_S, DT_D
623: ACT1-1, S1-1, D1-1, ACT1-2, S1-2, D1-2

# FIG. 21A

613: DT_ACT, DT_S, DT_D
623: ACT1-1, S1-1, D1-1, ACT1-2, S1-2, D1-2

# FIG. 21B

523    513

S1-2 ～    DT_S

BF ～

SUB1 ～

Europäisches
Patentamt

European
Patent Office

Office européen
des brevets

# EUROPEAN SEARCH REPORT

Application Number

EP 23 15 8012

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/408292 A1 (SOHN SANGWOO [KR] ET AL) 30 December 2021 (2021-12-30) | 1-4,9-13 | INV.<br>H01L27/12 |
| A | * abstract; figures 2, 7 *<br>* paragraphs [0110], [0114], [0115] * | 5,14,15 | H01L29/66 |
| A | US 2005/225253 A1 (YAMADA TSUTOMU [JP] ET AL) 13 October 2005 (2005-10-13)<br>* abstract; figures 2A-5B *<br>* paragraph [0030] * | 1-15 | |
| A | US 2004/211961 A1 (KOO JAE-BON [KR] ET AL) 28 October 2004 (2004-10-28)<br>* abstract; figures 2, 7, 10, 11, 15A-15i *<br>* paragraphs [0015], [0016], [0028], [0057], [0070] * | 1-15 | |
| A | WO 00/01016 A1 (MATSUSHITA ELECTRIC IND CO LTD [JP]; KURAMASU KEIZABURO [JP] ET AL.) 6 January 2000 (2000-01-06)<br>* abstract; figures 1,2, *<br>* claim 19 * | 1-15 | |

TECHNICAL FIELDS
SEARCHED       (IPC)

H01L

The present search report has been drawn up for all claims

| Place of search | Date of completion of the search | Examiner |
|---|---|---|
| Berlin | 21 June 2023 | Morena, Enrico |

EPO FORM 1503 03.82 (P04C01)

## ANNEX TO THE EUROPEAN SEARCH REPORT
## ON EUROPEAN PATENT APPLICATION NO.

EP 23 15 8012

This annex lists the patent family members relating to the patent documents cited in  the above-mentioned European search report.
The members are as contained in the European Patent Office EDP file on
The European Patent Office is in no way liable for these particulars which are merely given for the purpose of information.

21-06-2023

| Patent document cited in search report | | Publication date | Patent family member(s) | | Publication date |
|---|---|---|---|---|---|
| US 2021408292 | A1 | 30-12-2021 | CN | 113851486 A | 28-12-2021 |
| | | | KR | 20220001051 A | 05-01-2022 |
| | | | US | 2021408292 A1 | 30-12-2021 |
| US 2005225253 | A1 | 13-10-2005 | CN | 1681361 A | 12-10-2005 |
| | | | JP | 2005300786 A | 27-10-2005 |
| | | | KR | 20060046624 A | 17-05-2006 |
| | | | TW | 200533984 A | 16-10-2005 |
| | | | US | 2005225253 A1 | 13-10-2005 |
| US 2004211961 | A1 | 28-10-2004 | CN | 1540602 A | 27-10-2004 |
| | | | US | 2004211961 A1 | 28-10-2004 |
| WO 0001016 | A1 | 06-01-2000 | CN | 1307730 A | 08-08-2001 |
| | | | KR | 20010052812 A | 25-06-2001 |
| | | | TW | 454260 B | 11-09-2001 |
| | | | US | 6506669 B1 | 14-01-2003 |
| | | | US | 6534353 B1 | 18-03-2003 |
| | | | WO | 0001016 A1 | 06-01-2000 |

EPO FORM P0459

For more details about this annex : see Official Journal of the European Patent Office, No. 12/82